# EUROPEAN PATENT APPLICATION

(11) **EP 4 626 166 A1**
(43) Date of publication of application: **01.10.2025**
(21) Application number: 25158752.3
(22) Date of filing: 19.02.2025
(51) Int. Cl.: H10B 43/40, H01L 23/522

(54) **SEMICONDUCTOR DEVICES HAVING CAPACITOR STRUCTURES AND DATA STORAGE SYSTEMS INCLUDING THE SAME**

(30) Priority: 26.03.2024 KR 20240040951
(71) Applicant: Samsung Electronics Co., Ltd., Suwon-si, Gyeonggi-do 16677 (KR)
(72) Inventor: LEE, Seungmin, 16677 Suwon-si (KR); KANG, Minkyu, 16677 Suwon-si (KR); KIM, Gaeun, 16677 Suwon-si (KR); AN, Eunji, 16677 Suwon-si (KR); LEE, Taegon, 16677 Suwon-si (KR); LIM, Joonsung, 16677 Suwon-si (KR)
(74) Representative: Marks & Clerk LLP

(57) **Abstract**

A semiconductor device according to example embodiments of the present disclosure may include a first semiconductor structure including a substrate and circuit elements on the substrate, and a second semiconductor structure including a plate layer having at least one through-hole and a capacitor structure on a lower surface of the plate layer. The capacitor structure may include a first electrode structure on the lower surface of the plate layer, a second electrode structure that surrounds at least a portion of the first electrode structure and extends in the at least one through-hole, and a dielectric liner extending between the at least one through-hole and the second electrode structure and between the first electrode structure and the second electrode structure.

## Description

### BACKGROUND OF THE INVENTION

The present disclosure relates to semiconductor devices having capacitor structures and data storage systems including the same.

In a data storage system requiring data storage, a semiconductor device capable of storing high-capacitance data is helpful. Accordingly, manners by which to increase the data storage capacitance of a semiconductor device have been researched. For example, as one manner to increase the data storage capacitance of a semiconductor device, a semiconductor device including memory cells arranged three-dimensionally instead of memory cells arranged two-dimensionally has been proposed.

Additionally, as the high integration of semiconductor devices accelerates, an area that a capacitor may occupy inside a memory cell structure has been decreased.

In other words, with an increase in an integration level of the semiconductor device, the area occupied by the capacitor decreases, whereas the electrostatic capacity is maintained or increased. Accordingly, as an aspect ratio of the electrodes included in the capacitor increases, capacitor structures that may secure reliability and electrical characteristics are being proposed.

### SUMMARY OF THE INVENTION

An aspect of the present disclosure is to provide a semiconductor device including a capacitor structure securing electrostatic capacity and improving reliability.

Another aspect of the present disclosure is to provide a data storage system including a semiconductor device including the capacitor structure.

However, the objects of the present disclosure are not limited to the above-described objects, and may be variously extended without departing from the scope of the present disclosure.

A semiconductor device according to example embodiments of the present disclosure may include a first semiconductor structure including a substrate, circuit elements on the substrate, a lower interconnection structure electrically connected to the circuit elements, and a first metal bonding layer on the circuit elements and the lower interconnection structure; and a second semiconductor structure including a plate layer having at least one through-hole, gate electrodes stacked and spaced apart from each other in a first direction perpendicular to a lower surface of the plate layer, channel structures extending in the first direction through the gate electrodes, a capacitor structure spaced apart from the channel structures on the lower surface of the plate layer, and a second metal bonding layer below the channel structures and below the capacitor structure and bonded to the first metal bonding layer, wherein the capacitor structure includes a first electrode structure on the lower surface of the plate layer; a second electrode structure that surrounds at least a portion of the first electrode structure and extends in the at least one through-hole (e.g. is partially exposed through the at least one through-hole); and a dielectric liner that extends between the at least one through-hole and the second electrode structure and between the first electrode structure and the second electrode structure.

A semiconductor device according to example embodiments of the present disclosure may include a stack pattern including a cell array region, a cell contact region, and a peripheral region sequentially arranged in a first direction; a stack structure extending on the cell array region and the cell contact region of the stack pattern, wherein the stack structure includes interlayer insulating layers and gate electrodes alternately arranged in a vertical direction intersecting the first direction; a channel structure extending in the vertical direction through the stack structure on the cell array region; contact plugs extending through ones of the gate electrodes and ones of the interlayer insulating layers on the cell contact region; and a capacitor structure on the peripheral region of the stack pattern and including an expansion cavity, wherein the capacitor structure includes a first electrode structure on the stack pattern and in the expansion cavity; a dielectric liner on the first electrode structure in the expansion cavity and on an inner surface of the expansion cavity; and a second electrode structure on the dielectric liner.

A data storage system according to example embodiments of the present disclosure may include a semiconductor storage device including a first semiconductor structure including circuit elements and circuit interconnections electrically connected to the circuit elements, a second semiconductor structure on a surface of the first semiconductor structure and including a first region, a second region, and a third region, and an input/output pad electrically connected to the circuit elements; and a controller electrically connected to the semiconductor storage device through the input/output pad and configured to control the semiconductor storage device, wherein the second semiconductor structure includes a plate layer including at least one through-hole on the third region and including a front surface and a rear surface opposing each other; gate electrodes stacked and spaced apart from each other in a first direction perpendicular to the rear surface of the plate layer, each of the gate electrodes including a pad region; a channel structure extending in the first direction through the gate electrodes in the first region; contact plugs extending in the first direction through the pad region of respective ones of the gate electrodes in the second region, the contact plugs electrically connecting the respective ones of the gate electrodes to a portion of the circuit interconnections; and a capacitor structure that is on the rear surface of the plate layer in the third region and is overlapped by the at least one through-hole in the first direction, wherein the capacitor structure includes a first electrode structure that extends in the first direction on the rear surface of the plate layer; a second electrode structure that surrounds at least a portion of the first electrode structure and extends in the at least one through-hole; and a dielectric liner that extends between the at least one through-hole and the second electrode structure and between the first electrode structure and the second electrode structure, and wherein the second electrode structure and the dielectric liner conformally extend along at least a portion of the first electrode structure.

Semiconductor devices and data storage systems including the same according to example embodiments of the present disclosure may include a first electrode structure having a cylindrical shape extending in a vertical direction on a memory cell structure, a dielectric liner on the first electrode structure, and a second electrode structure, so that the semiconductor devices and the data storage systems including the same can secure a capacitor structure having improved reliability and electrical characteristics.

At least some of the above and other features of the invention are set out in the claims. However, advantages and effects of the present disclosure are not limited to the foregoing content and may be variously extended without departing from the scope of the present disclosure

### BRIEF DESCRIPTION OF DRAWINGS

The above and other aspects, features, and advantages of the present disclosure will be more clearly understood from the following detailed description, taken in conjunction with the accompanying drawings, in which:
FIG. 1A is a schematic block diagram of a semiconductor device according to example embodiments of the present disclosure;
FIG. 1B is a circuit diagram illustrating a charge pump circuit included in a voltage generator of a semiconductor device according to example embodiments;
FIG. 1C is a schematic perspective view of a semiconductor device according to example embodiments;
FIG. 1D is a schematic plan view of a semiconductor device according to example embodiments;
FIG. 2A is a cross-sectional view taken along line I-I' of the semiconductor device of FIG. 1D according to example embodiments;
FIG. 2B is a cross-sectional view taken along line II-II' of the semiconductor device of FIG. 1D according to example embodiments;
FIG. 3 is an enlarged view of region A of the semiconductor device of FIG. 2A according to example embodiments;
FIGS. 4A and 4B are enlarged views of the capacitor structure of FIG. 2A according to further example embodiments;
FIG. 5 is a plan view illustrating a layout of a capacitor structure according to example embodiments;
FIG. 6A is a plan view illustrating a layout of a capacitor structure according to further example embodiments;
FIG. 6B is a cross-sectional view taken along line III-III' of the capacitor structure of FIG. 6A according to example embodiments;
FIG. 7 is a plan view illustrating a layout of a capacitor structure according to further example embodiments;
FIG. 8A is a plan view illustrating a layout of a capacitor structure according to further example embodiments;
FIG. 8B is a cross-sectional view taken along line IV-IV' of the capacitor structure of FIG. 8A according to example embodiments;
FIGS. 9A to 9H are views illustrating a method of manufacturing a semiconductor device according to example embodiments;
FIG. 10 is a cross-sectional view taken along line I-I' of the semiconductor device of FIG. 1D according to further example embodiments;
FIG. 11 is a view schematically illustrating a data storage system including a semiconductor device according to example embodiments of the present disclosure;
FIG. 12 is a perspective view schematically illustrating a data storage system including a semiconductor device according to example embodiments of the present disclosure; and
FIG. 13 is a cross-sectional view schematically illustrating a semiconductor package according to example embodiments of the present disclosure.

### DETAILED DESCRIPTION

Hereinafter, example embodiments of the present disclosure will be described with reference to the accompanying drawings. The same reference numerals are used for the same components in the drawings, and duplicate descriptions for the same components may be omitted.

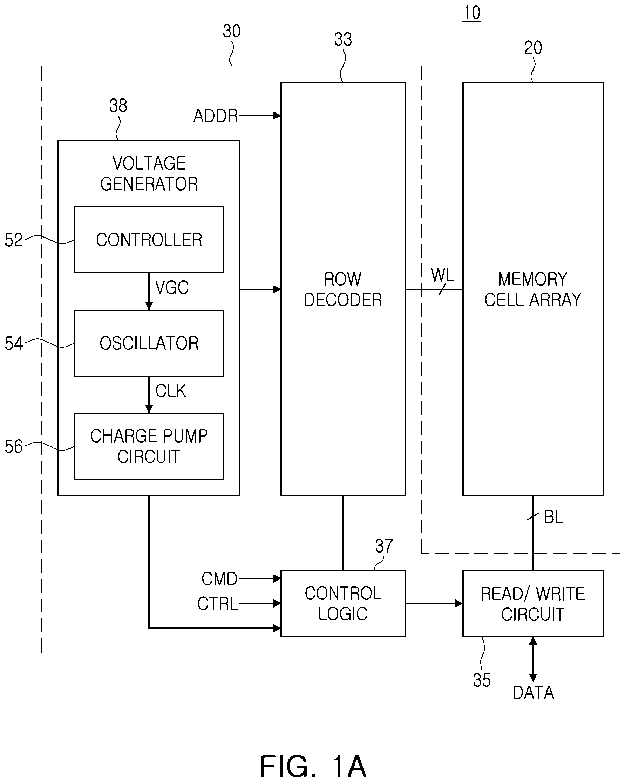

FIG. 1A is a schematic block diagram of a semiconductor device according to example embodiments of the present disclosure.

Referring to FIG. 1A, a semiconductor device 10 may include a memory cell array 20 and a peripheral circuit 30. The semiconductor device 10 may be a memory device, for example, a non-volatile memory such as a flash memory, or a volatile memory such as a dynamic random access memory (DRAM) or a static random access memory (SRAM).

The memory cell array 20 may include a plurality of memory cells. The plurality of memory cells may be connected to a row decoder 33 through a plurality of word lines WL, and may be connected to a read/write circuit 35 through bit lines BL. In an example, a plurality of memory cells arranged along the same row may be connected to the same word line WL, and a plurality of memory cells arranged along the same column may be connected to the same bit line BL. In some example embodiments, the memory cell array 20 may include a plurality of memory blocks, and each memory block may include a plurality of memory cells.

The peripheral circuit 30 may receive an address ADDR, a command CMD, and a control signal CTRL from the outside of the semiconductor device 10 (e.g., from an external device), and may transmit and receive data DATA with a device external to the semiconductor device 10. The peripheral circuit 30 may include a row decoder 33, a read/write circuit 35, a control logic 37, and a voltage generator 38 configured to generate various voltages required for an operation. According to example embodiments, the peripheral circuit 30 may further include various sub-circuits, such as an input/output (I/O) circuit and an error correction circuit for correcting errors in data DATA read from the memory cell array 20.

The control logic 37 may be coupled to the row decoder 33, the voltage generator 38, and the input/output circuit. The control logic 37 may control an overall operation of the semiconductor device 10. The control logic 37 may generate various internal control signals used in the semiconductor device 10 in response to the control signal CTRL. For example, the control logic 37 may adjust a voltage level provided to the word lines WL and the bit lines BL when performing a memory operation such as a program operation or an erase operation.

The row decoder 33 may select some of the plurality of memory cells in response to the address ADDR, and may select at least one word line WL. The row decoder 33 may transmit a voltage for performing a memory operation to the selected word line WL.

The read/write circuit 35 may be connected to the memory cell array 20 through the bit lines BL. The read/write circuit 35 may include a writer driver and/or a sense amplifier. Specifically, during a program operation, the read/write circuit 35 may operate as a write driver and apply a voltage according to the data DATA to be stored in the memory cell array 20 to the bit lines BL. Meanwhile, during a read operation, the read/write circuit 35 operates as a sense amplifier and may detect data DATA stored in the memory cell array 20.

The voltage generator 38 may include a controller 52, an oscillator 54, and a charge pump 56.

The charge pump 56 may include a plurality of charge pumps, and each of the plurality of charge pumps may include at least one switch element and at least one pumping capacitor. The charge pump 56 may provide a current through the row decoder 33 to apply an operating voltage to the word line WL of the memory cell array 20.

The controller 52 may control the operation of the oscillator 54. For example, the controller 52 may determine one selected charge pump among the plurality of charge pumps, based on at least one of PVT (Process, Voltage, Temperature) information of the semiconductor device 10 and a target level of a power voltage to be supplied. The controller 52 may deactivate all charge pumps except the selected charge pump.

The oscillator 54 may output a clock signal CLK. The oscillator 54 may operate in response to a control signal VGC from controller 52. For example, the oscillator 54 may output the clock signal CLK to at least some of the plurality of charge pumps, in response to the control signal VGC transmitted by the controller 52.

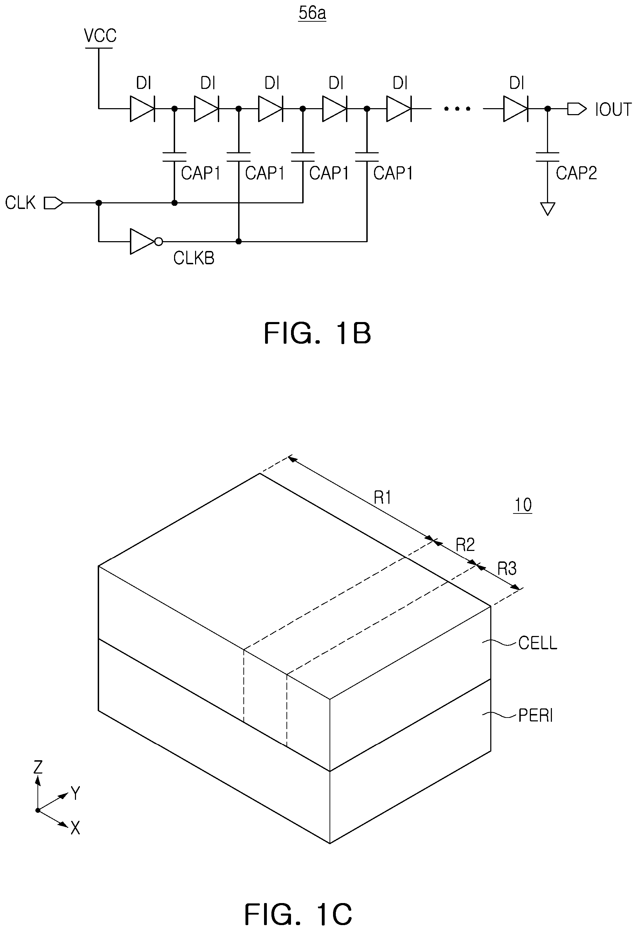

FIG. 1B is a circuit diagram illustrating a charge pump circuit included in a voltage generator of a semiconductor device according to example embodiments.

Referring to FIG. 1B, the charge pump circuit 56a may include a plurality of diodes DI, a plurality of pumping capacitors CAP 1, and an output capacitor CAP2. The plurality of diodes DI may be connected to each other in series, and the plurality of pumping capacitors CAP1 may be connected to nodes between the plurality of diodes DI. A first diode DI may receive a power supply voltage VCC having a predetermined level, and a last diode DI may output an output current IOUT to an output node.

Each of the plurality of pumping capacitors CAP1 may be charged or discharged by the clock signal CLK or a complementary clock signal CLKB phase-converted to have an opposite phase to the clock signal CLK by an inverter. For example, odd-numbered pumping capacitors CAP1 may be charged or discharged by the clock signal CLK, and even-numbered pumping capacitors CAP 1 may be charged or discharged by the complementary clock signal CLKB.

FIG. 1C is a schematic perspective view of a semiconductor device according to example embodiments.

Referring to FIG. 1C, the semiconductor device 10 may include a peripheral circuit structure PERI and a memory cell structure CELL stacked in a vertical direction (Z-direction). The memory cell structure CELL may be disposed on the peripheral circuit structure PERI. In other example embodiments, the memory cell structure CELL may be disposed below the peripheral circuit structure PERI.

The memory cell structure CELL may include first, second, and third regions R1, R2 and R3. The first region R1 and the second region R2 may be regions in which the memory cell array 20 of FIG. 1A and an upper interconnection structure connected to the memory cell array 20 are disposed. The first region R1 may be a region in which memory cells are disposed, and the second region R2 may be a region for electrically connecting the word lines WL to the peripheral circuit 30 of FIG. 1A. The third region R3 may be a region in which a plurality of pumping capacitors CAP 1 of the charge pump circuits 56 and 56a of FIGS. 1A and 1B are disposed.

The peripheral circuit structure PERI may include various circuit elements included in the peripheral circuit 30. For example, the peripheral circuit structure PERI may include the row decoder 33, the read/write circuit 35, and the control logic 37 of FIG. 1A.

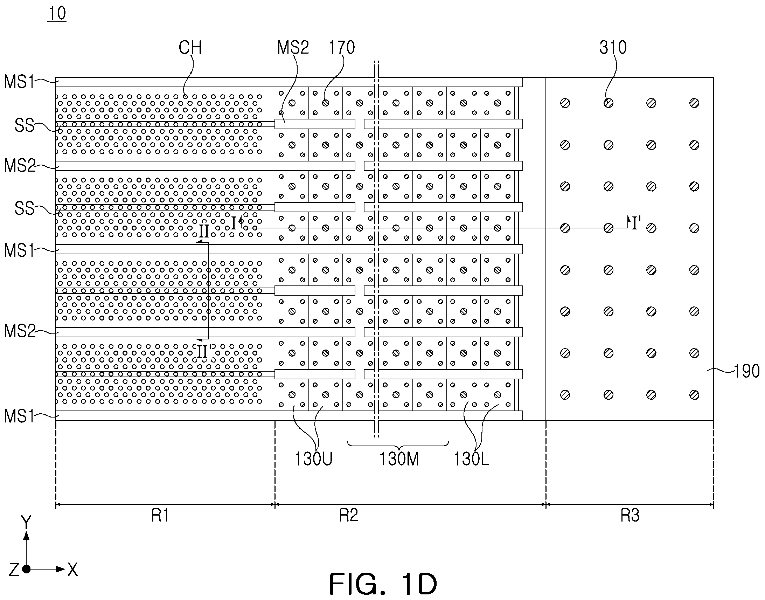

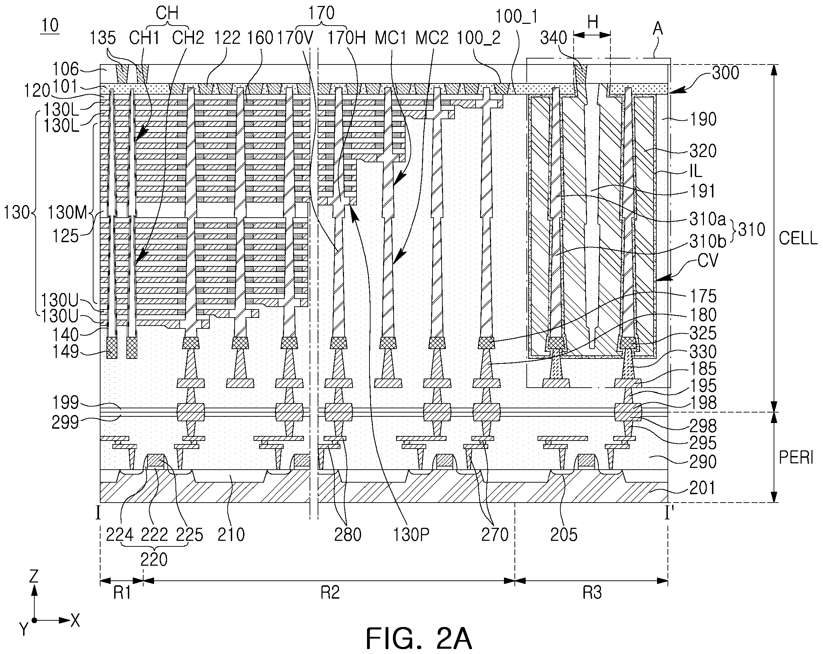

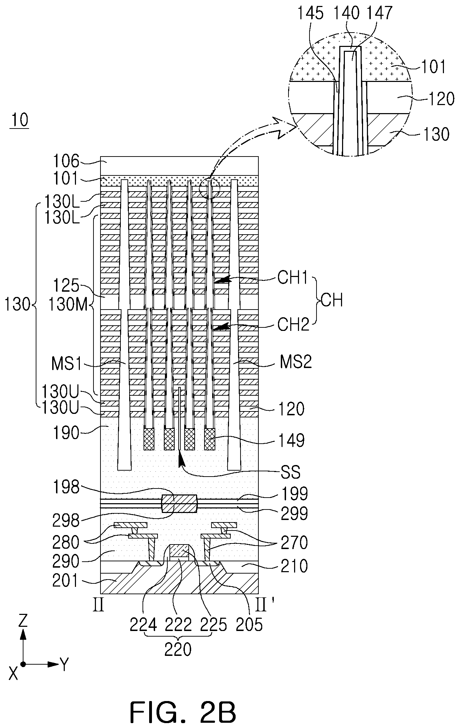

FIG. 1D is a schematic plan view of a semiconductor device according to example embodiments. FIG. 2A is a cross-sectional view taken along line I-I' of the semiconductor device of FIG. 1D according to example embodiments. FIG. 2B is a cross-sectional view taken along line II-II' of the semiconductor device of FIG. 1D according to example embodiments.

Referring to FIGS. 1D, 2A, and 2B, the semiconductor device 10 may include a peripheral circuit structure PERI as a first semiconductor structure, and a memory cell structure CELL as a second semiconductor structure, which are bonded using a wafer bonding method. As used herein, the peripheral circuit structure PERI may also be referred to as a first semiconductor structure, and the memory cell structure CELL may also be referred to as a second semiconductor structure.

The peripheral circuit structure PERI may include a substrate 201, impurity regions 205 and device separation regions 210 inside the substrate 201, circuit elements 220 disposed on the substrate 201, circuit contact plugs 270, and circuit interconnection lines 280, a peripheral region insulating layer 290, and a peripheral bonding structure. The peripheral bonding structure may include first bonding vias 295, a first metal bonding layer 298, and a first bonding insulating layer 299.

The substrate 201 may have an upper surface extending in a first direction (X-direction) and a second direction (Y-direction). For example, the first direction (X-direction) and the second direction (Y-direction) may intersect each other and may be substantially parallel to the upper surface of the substrate 201. As another example, a third direction (Z-direction) may intersect the first direction (X-direction) and the second direction (Y-direction) and may be substantially perpendicular to the upper surface of the substrate 201. An active region may be defined in the substrate 201 by the device separation regions 210. The impurity regions 205, which are source/drain regions, may be disposed in a portion of the active region. The substrate 201 may include a semiconductor material, such as a group IV semiconductor, a group III-V compound semiconductor, or a group II-VI compound semiconductor. The substrate 201 may be provided as a bulk wafer or an epitaxial layer.

The circuit elements 220 may include planar transistors. Each of the circuit elements 220 may include a circuit gate dielectric layer 222, a spacer layer 224, and a circuit gate electrode 225. The impurity regions 205 may be disposed in the substrate 201 on both (i.e., opposing) sides of the circuit gate electrode 225. As used herein, the circuit elements 220 and the impurity regions 205 may also be collectively referred to as circuit elements.

The peripheral region insulating layer 290 may be disposed on the circuit element 220 on the substrate 201. The circuit contact plugs 270 may penetrate through (i.e., extend through) the peripheral region insulating layer 290 and may be connected to the impurity regions 205. An electrical signal may be applied to the circuit element 220 through the circuit contact plugs 270. In a region not illustrated, the circuit contact plugs 270 may also be connected to the circuit gate electrode 225. The circuit interconnection lines 280 may be connected to the circuit contact plugs 270 and may be arranged in a plurality of layers. As used herein, the circuit contact plugs 270 and the circuit interconnection lines 280 may also be referred to as a lower interconnection structure.

The first bonding vias 295 may be disposed on an upper portion of the circuit contact plug 270 and the circuit interconnection lines 280. At least a portion of the first metal bonding layers 298 may be connected to the first bonding vias 295. The first metal bonding layers 298 may be connected to second metal bonding layers 198 of the memory cell structure CELL. The first metal bonding layers 298, together with the second metal bonding layers 198, may provide an electrical connection path for bonding the memory cell structure CELL and the peripheral circuit structure PERI. In another example, a portion of the first metal bonding layers 298 may not be connected to the circuit interconnection lines 280, and may be disposed only for bonding purposes.

The first bonding vias 295 and the first metal bonding layers 298 may include a conductive material, for example, copper (Cu). The first bonding insulating layer 299 may be disposed around the first metal bonding layers 298. The first bonding insulating layer 299 may also function as a diffusion barrier for the first metal bonding layers 298, and may include, for example, at least one of SiN, SiON, SiCN, SiOC, SiOCN, or SiO.

The memory cell structure CELL may include first, second, and third regions R1, R2 and R3. The first, second and third regions R1, R2, and R3 may be sequentially arranged in the first direction (X-direction). As used herein, the first region R1 may also be referred to as a cell array region, the second region R2 may also be referred to as a cell contact region, and the third region R3 may also be referred to as a peripheral region. In an example, the memory cell structure CELL may include a plate layer 101, a passivation layer 106, gate electrodes 130 stacked on a lower surface of the plate layer 101, interlayer insulating layers 120 alternately stacked with gate electrodes 130 to form a gate structure, a channel structure CH disposed to penetrate through the gate electrodes 130 and the interlayer insulating layers 120 in the first region R1, cell contact plugs 170 connected to the gate electrodes 130 in the second region R2 and extending vertically (i.e., extending in the third direction (Z-direction)), a capacitor structure 300 disposed on a lower surface of the plate layer 101 in the third region R3, a cell region insulating layer 190 on (e.g., covering) the gate electrodes 130 and the capacitor structure 300, and a cell bonding structure. The cell bonding structure may include second bonding vias 195, a second metal bonding layer 198, and a second bonding insulating layer 199. For example, the second bonding vias 195, the second metal bonding layer 198, and the second bonding insulating layer 199 may be below the channel structures CH, the cell contact plugs 170, and the capacitor structure 300.

The plate layer 101 may include a first surface 100_1 and a second surface 100_2 opposing the first surface 100_1. In the third direction (Z-direction), the first surface 100_1 may be a lower surface, and the second surface 100_2 may be an upper surface. As used herein, the first surface 100_1 may also be referred to as a lower surface or a rear surface, and the second surface 100_2 may also be referred to as an upper surface or a front surface. The plate layer 101 may include any one of polysilicon doped with impurities or polysilicon not doped with impurities. As used herein, the plate layer 101 may also be referred to as a stack pattern. For example, the stack pattern may include the first region R1, the second region R2, and the third region R3. For example, the plate layer 101 may be a source plate layer including a conductive material. As used herein, a direction in parallel with (i.e., parallel to) the first surface 100_1 and the second surface 100_2 of the plate layer 101 may also be referred to as the first direction (X-direction) and the second direction (Y-direction). The first and second directions may define a horizontal plane. As used herein, a direction perpendicular to the first surface 100_1 and the second surface 100_2 of the plate layer 101 and intersecting the first direction (X-direction) and the second direction (Y-direction) may also be referred to as a vertical direction (Z-direction) or the third direction (Z-direction).

The plate layer 101 may include a through-hole H in the third region R3. The through-hole H may be an opening penetrating through the plate layer 101. A dielectric liner IL and a second electrode structure 320 of the capacitor structure 300 to be described below may be exposed through the through-hole H.

The passivation layer 106 may be disposed on the second surface 100_2 of plate layer 101, and may protect the semiconductor device 10. The passivation layer 106 may include at least one of insulating materials. For example, the passivation layer 106 may include at least one of silicon oxide, silicon nitride, or silicon carbide.

A memory cell array (e.g., the memory cell array 20 of FIG. 1A) including a plurality of memory cells may be formed on the first region R1. Gate electrodes 130 and a channel structure CH may be disposed on the first surface 100_1 of the plate layer 101 in the first region R1.

The second region R2 may be disposed in the first direction (X-direction) of the first region R1, and the gate electrodes 130 may be stacked in a stepwise shape (e.g., a staircase shape). For example, the second region R2 may be adjacent the first region R1 in the first direction (X-direction). The cell contact plugs 170 may be disposed on the first surface 100_1 of the plate layer 101 in the second region R2.

The third region R3 may be disposed outside the first region R1 and the second region R2, and the capacitor structure 300 may be disposed on the first surface 100_1 of the plate layer 101 in the third region R3.

The gate electrodes 130 may be stacked vertically and spaced apart from each other on the first surface 100_1 of the plate layer 101 to form a stack structure together with the interlayer insulating layers 120. The stack structure may include vertically stacked lower and upper stack structures. The gate electrodes 130 may include first gate electrodes 130U included in string select transistors, second gate electrodes 130L included in ground select transistors, and memory gate electrodes 130M disposed between the first gate electrodes 130U and the second gate electrodes 130L. The number of memory gate electrodes 130M included in memory cells may be determined depending on the capacitance of the semiconductor device 10.

The gate electrodes 130 may be stacked vertically and spaced apart from each other in the first region R1, may extend to the second region R2 in the first direction (X-direction) and may extend at different lengths, thereby forming a step structure in the form of a stepwise arrangement. Due to the step structure, the second gate electrodes 130L disposed in an upper portion may extend to be longer than the first gate electrodes 130U disposed in a lower portion, so that each of the gate electrodes 130 may have contact regions 130P exposed downwardly from the interlayer insulating layers 120. The gate electrodes 130 may be respectively connected to the cell contact plugs 170 in the contact regions 130P, which are end regions. As used herein, the contact regions 130P may also be referred to as pad regions.

The gate electrodes 130 may be arranged to be separated from each other in the second direction (Y-direction) by a first separation region MS1 extending in the first direction (X-direction). The gate electrodes 130 between a pair of first separation regions MS1 may be included in one memory block, and a range of the memory block is not limited thereto.

The gate electrodes 130 may include a metallic material, and may include, for example, tungsten (W). According to some example embodiments, the gate electrodes 130 may include a polycrystalline silicon material or a metal silicide material. The gate electrodes 130 may entirely include the same material. In example embodiments, the gate electrodes 130 may further include a diffusion barrier, and for example, the diffusion barrier may include tungsten nitride (WN), tantalum nitride (TaN), titanium nitride (TiN), or a combination thereof.

The interlayer insulating layers 120 may be disposed between the gate electrodes 130. For example, respective ones of the interlayer insulating layers 120 may be between adjacent ones of the gate electrodes 130. Similarly to the gate electrodes 130, the interlayer insulating layers 120 may be spaced apart from each other on the first surface 100_1 of the plate layer 101 in a vertical direction (Z-direction) and may extend in the first direction (X-direction). The interlayer insulating layers 120 may include an insulating material such as silicon oxide or silicon nitride.

Referring to FIGS. 1D and 2B, the first and second separation regions MS1 and MS2 may be arranged to extend in the first direction (X-direction) by penetrating through the gate electrodes 130. The first and second separation regions MS1 and MS2 may be arranged in parallel with each other. The first and second separation regions MS1 and MS2 may entirely penetrate through the gate electrodes 130 stacked on the first surface 100_1 of the plate layer 101 and may be connected to the plate layer 101. The first separation regions MS1 may extend as one in the first direction (X-direction), and the second separation regions MS2 may extend intermittently between the pair of first separation regions MS1 or may be disposed only in a partial region. However, in example embodiments, the arrangement order and number of first and second separation regions MS1 and MS2 are not limited to those shown in FIG. 1D.

As illustrated in FIG. 1D, upper separation regions SS may extend in the first direction (X-direction) between the first separation regions MS1 and the second separation regions MS2 in the first region R1. As illustrated in FIG. 2B, the upper separation regions SS may separate a subset of gate electrodes 130, for example, a total of three gate electrodes 130, including the first gate electrodes 130U, from each other in the second direction (Y-direction). However, the number of gate electrodes 130 separated by the upper separation regions SS may be variously changed in example embodiments. The first gate electrodes 130U separated by the upper separation regions SS may form different string select lines. The upper separation regions SS may include an insulating material, and may include, for example, silicon oxide, silicon nitride, or silicon oxynitride.

Referring to FIGS. 1D, 2A, and 2B, the channel structure CH may extend in the third direction (Z-direction) by penetrating through the gate electrodes 130, and may be connected to the plate layer 101. Each of the channel structures CH may be included in one memory cell string, and may be spaced apart from each other in rows and columns on the lower surface of the plate layer 101. The channel structures CH may be arranged to have a grid pattern or may be arranged to have a zigzag shape in one direction, in an X-Y plane. The channel structures CH may have a pillar shape and may have an inclined side surface so that the channel structures CH become narrower as they approach the plate layer 101.

The channel structures CH may include a first channel portion CH1 and a second channel portion CH2 that are vertically stacked. The channel structures CH may have a shape in which the first channel portion CH1 and the second channel portion CH2 are connected, and may have a bent portion due to a difference in width in an interface between the first channel portion CH1 and the second channel portion CH2. However, according to example embodiments, the number of channel structures stacked in the third direction (Z-direction) may be variously changed.

Each of the channel structures CH may include a channel layer 140, a channel dielectric layer 145, a channel buried insulating layer 147 and a lower channel pad 149, which are disposed inside a channel hole. The channel layer 140 may be connected between the first channel portion CH1 and the second channel portion CH2. The channel layer 140 may include a protruding portion and a non-protruding portion. The channel layer 140 may be formed to have an annular shape surrounding the channel buried insulating layer 147 inside the channel hole (e.g., when viewed in plan).

According to example embodiments, the channel layer 140 may have a pillar shape such as a cylinder or a prism without the channel buried insulating layer 147. The protruding portion of the channel layer 140 may be connected to the plate layer 101. The channel layer 140 may include a semiconductor material such as polycrystalline silicon or amorphous silicon, and the semiconductor material may be an undoped material or a material including P-type or N-type impurities. Channel pads 149 may be disposed below the channel layer 140 in the channel structures CH. The channel pads 149 may be arranged to be on (e.g., to cover) a lower surface of the channel buried insulating layer 147 and may be electrically connected to the channel layer 140. The channel pads 149 may include, for example, doped polycrystalline silicon. The channel dielectric layer 145 may be disposed between the gate electrodes 130 and the channel layer 140. An uppermost end of the channel dielectric layer 145 may be disposed on a lower level than an upper surface of the channel layer 140. As used herein, the term "level" may refer to a height or distance in a vertical direction (e.g., the Z-direction) from a lower surface of the substrate 201. The channel dielectric layer 145 may include a tunneling layer, a charge storage layer, and a blocking layer sequentially stacked on the channel layer 140. The tunneling layer may tunnel charges into the charge storage layer, and may include, for example, silicon oxide (SiO₂), silicon nitride (Si₃N₄), silicon oxynitride (SiON), or combinations thereof. The charge storage layer may be a charge trap layer or a floating gate conductive layer. The blocking layer may include silicon oxide (SiO₂), silicon nitride (Si₃N₄), silicon oxynitride (SiON), high-κ dielectric material, or combinations thereof. According to example embodiments, at least a portion of the channel dielectric layer 145 may extend along the gate electrodes 130 in a horizontal direction.

An interlayer insulating layer 125 with a relatively thick intermediate may be disposed between the first channel portion CH1 and the second channel portion CH2, that is, between a lower stack structure and an upper stack structure. However, the shapes of the interlayer insulating layers 120 and the intermediate interlayer insulating layers 125 may be variously changed according to example embodiments.

A channel contact plug 135 may be disposed on the plate layer 101 to which the channel layer 140 of the channel structure CH is connected. The channel contact plug 135 may be electrically connected to the lower interconnection structure of the peripheral circuit structure PERI in a region not illustrated. A signal for lowering resistance of the plate layer 101 to which the channel layer 140 is connected may be applied to the channel contact plug 135.

The cell contact plugs 170 may be connected to the contact regions 130P of the gate electrodes 130. The cell contact plugs 170 may penetrate through at least a portion of the cell region insulating layer 190, and may be connected to each of the contact regions 130P of the gate electrodes 130 exposed downwardly. The cell contact plugs 170 may penetrate through the gate electrodes 130 on the contact regions 130P, and may be embedded inside the plate layer 101.

Each of the cell contact plugs 170 may have a shape extending horizontally from the contact region 130P. The cell contact plugs 170 may include a vertical extension portion 170V extending in the vertical direction (Z-direction) and a horizontal extension portion 170H extending horizontally from the vertical extension portion 170V and contacting the gate electrode 130. The horizontal extension portion 170H may be disposed along a circumference of the vertical extension portion 170V, and an entire side surface thereof may be surrounded by the gate electrode 130. The cell contact plugs 170 may be spaced apart from the gate electrodes 130 below the contact regions 130P, that is, gate electrodes 130 not electrically connected, by the contact insulating layers 160. For example, the cell contact plugs 170 may be electrically connected to respective ones of the gate electrodes 130 in the contact regions 130P and may be spaced apart from (i.e., electrically isolated from) remaining ones of the gate electrodes 130 by the contact insulating layers 160. It will be understood that "an element A surrounds an element B" (or similar language) as used herein means that the element A is at least partially around the element B but does not necessarily mean that the element A completely encloses the element B.

The cell contact plugs 170 may have a shape corresponding to the channel structures CH. Each of the cell contact plugs 170 may include a first contact portion MC1 and a second contact portion MC2 stacked from the first surface 100_1 of the plate layer 101. The first and second contact portions MC1 and MC2 may have a cylindrical shape in which a width thereof decreases toward the plate layer 101 due to an aspect ratio. Each of the first and second contact portions MC1 and MC2 may have a substantially constant slope. An upper surface of the first contact portion MC1 may be buried in the plate layer 101. The first and second contact portions MC1 and MC2 may have a bent portion due to a difference in width in a region in which the first and second contact portions MC1 and MC2 are connected to each other or in an interface thereof. However, according to example embodiments, the number of contact plugs stacked in the third direction (Z-direction) may be variously changed. In an example, a level of the interface between the first contact portion MC1 and the second contact portion MC2 may be the same as a level of an interface between the first channel portion CH1 and the second channel portion CH2. In an example, a level of a lower surface of the first contact portion MC1 may be the same as a level of a lower surface of the first channel portion CH1, and a level of a lower surface of the second contact portion MC2 may be the same as a level of a lower surface of the second channel portion CH2.

Each of the cell contact plugs 170 may not be electrically connected to (i.e., may be electrically isolated from) the channel structures CH and the capacitor structure 300 by a contact insulating structure 122 surrounding a portion of the cell contact plugs 170 embedded in the plate layer 101. The contact insulating structure 122 may be a cylindrical insulating structure in which a width thereof becomes narrower toward the plate layer 101 (e.g., toward the first surface 100_1 of the plate layer 101).

The cell contact plugs 170 may include a conductive material, for example, at least one of tungsten (W), copper (Cu), aluminum (Al), or alloys thereof. In some embodiments, the cell contact plugs 170 may include a barrier layer extending along a side surface and a bottom surface thereof, or may have an air gap therein.

The capacitor structure 300 may be disposed in the third region R3 by being spaced apart from the channel structures CH and the cell contact plugs 170 in the first direction (X-direction). The capacitor structure 300 may include a first electrode structure 310, a second electrode structure 320, a dielectric liner IL, a first contact electrode 330 disposed below the first electrode structure 310, a second contact electrode 340 disposed above the second electrode structure 320, and an insulating pattern 191.

The first electrode structure 310 may extend on the first surface 100_1 of the plate layer 101 in the vertical direction (Z-direction).

The first electrode structure 310 may have a shape corresponding to (e.g. the same as) the cell contact plugs 170. In an example, the first electrode structure 310 may be provided and/or formed in the same process as the cell contact plugs 170. However, the present disclosure is not limited thereto. For example, the first electrode structure 310 may be provided and/or formed in a process that is different from that of the cell contact plugs 170.

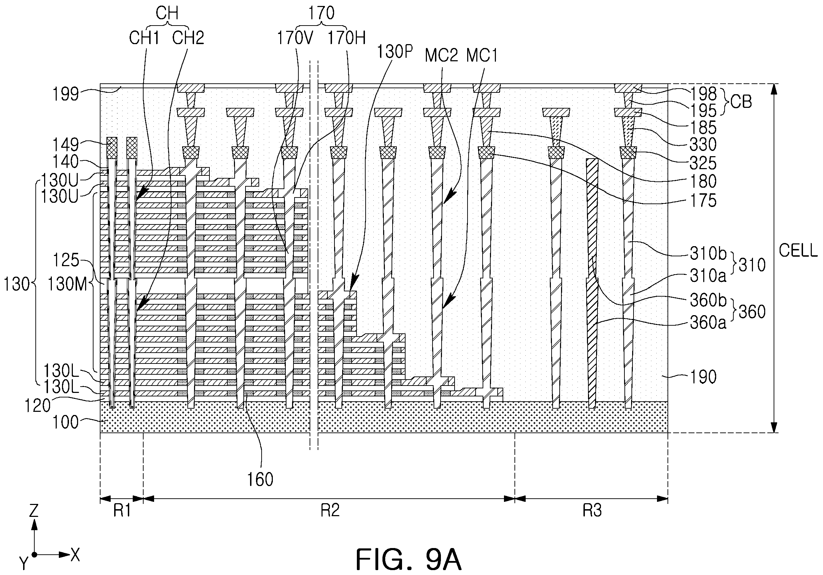

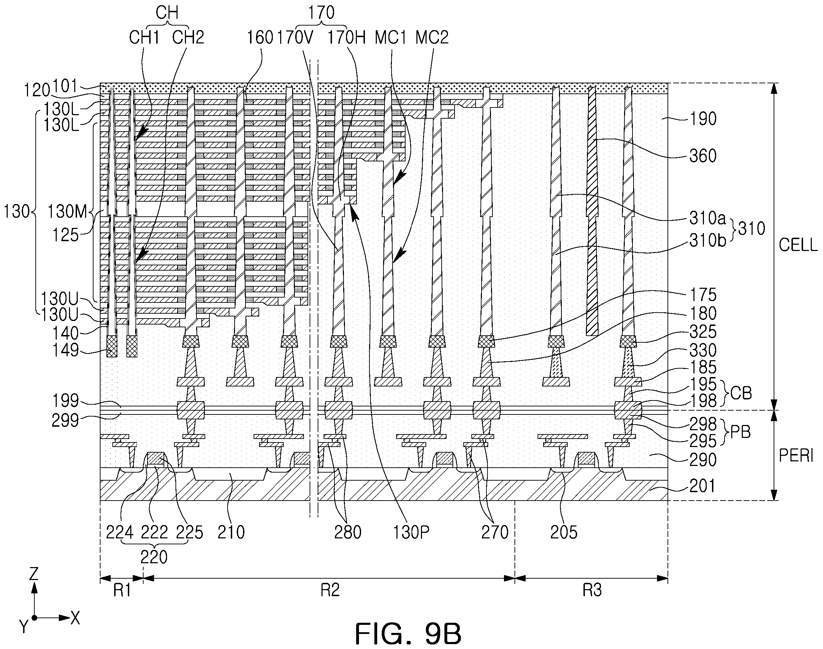

Each of the first electrode structures 310 may include a first lower electrode 310a and a first upper electrode 310b stacked from the first surface 100_1 of the plate layer 101. In some example embodiments, a method of manufacturing the semiconductor device 10 may include flipping the memory cell structure CELL vertically (e.g., in the vertical direction (Z-direction)) to bond the memory cell structure CELL to the peripheral circuit structure PERI (e.g., see FIGS. 9A and 9B). Before the memory cell structure CELL is flipped, the first lower electrode 310a may be below the first upper electrode 310b (e.g., see FIG. 9A), and thus the first lower electrode 310a may be considered a lower electrode. It will be understood that the first lower electrode 310a and the first upper electrode 310b are not limited by these terms. For example, as used herein, the first lower electrode 310a may also be referred to as a first upper electrode 310a, and, similarly, the first upper electrode 310b may also be referred to as a first lower electrode 310b, without departing from the scope of the present disclosure. An upper surface of the first lower electrode 310a may be embedded in the plate layer 101. The first lower electrode 310a and the first upper electrode 310b may have a cylindrical shape in which a width thereof decreases toward the plate layer 101 due to the aspect ratio. Each of the first lower electrode 310a and the first upper electrode 310b may have a substantially constant inclination. The first lower electrode 310a and the first upper electrode 310b may have a bent portion due to a difference in width in a region in which the first lower electrode 310a and the first upper electrode 310b are connected to each other or an interface thereof. However, according to example embodiments, the number of cylindrical electrodes stacked in the third direction (Z-direction) may be variously changed.

A stack shape of the first electrode structure 310 may be the same as a stack shape of the cell contact plug 170. In an example, a shape of the first lower electrode 310a and the first upper electrode 310b of the first electrode structure 310 may be the same as a shape of the first contact portion MC1 and the second contact portion MC2 of the cell contact plug 170. In an example, a level of an interface between the first lower electrode 310a and the first upper electrode 310b may be the same as a level of an interface between the first contact portion MC1 and the second contact portion MC2. In an example, a level of a lower surface of the first lower electrode 310a may be the same as a level of a lower surface of the first contact portion MC1, and a level of a lower surface of the first upper electrode 310b may be the same as a level of a lower surface of the second contact portion MC2. For example, upper surfaces of the contact plugs 170 may be coplanar with an upper surface of the first lower electrode 310a, and lower surfaces of the contact plugs 170 may be coplanar with a lower surface of the first upper electrode 310b. In an example, the first electrode structure 310 may be embedded in the plate layer 101. In an example, the first electrode structure 310 may penetrate through at least a portion of the cell region insulating layer 190 and may be embedded in the plate layer 101.

A contact pad 325 and a first contact electrode 330 may be disposed below the first upper electrode 310b. The contact pad 325 may be disposed on the same level as a cell lower pad 175. The first contact electrode 330 may be disposed on the same level as studs 180. In another example, the contact pad 325 may be omitted. The first contact electrode 330 may be disposed below the first upper electrode 310b.

An expansion cavity CV may define a space in the third region R3 in which the dielectric liner IL and the second electrode structure 320 are accommodated. The expansion cavity CV may refer to a cylindrical space having a side surface spaced apart from a center of the through-hole H by a predetermined distance, along an axis that passes through the center and is parallel to the vertical direction (Z-direction). The expansion cavity CV (otherwise known as a first cavity, or an electrode cavity) may accommodate at least a portion of the first electrode structure 310. For example, the expansion cavity CV may be on the first surface 100_1 of the plate layer 101. For example, the expansion cavity CV may be included in the capacitor structure 300.

The expansion cavity CV may include a side surface extending in the vertical direction (Z-direction) and a bottom surface extending from the side surface in the horizontal direction. The side surface of the expansion cavity CV may be substantially parallel to the vertical direction (Z-direction), and the bottom surface of the expansion cavity CV may be substantially parallel to the horizontal direction (e.g. the horizontal plane, defined by the X-direction and Y-direction). In some example embodiments, the first contact electrode 330 may protrude from the bottom surface of the expansion cavity CV. For example, a portion of the first contact electrode 330 adjacent to a lower surface of the first electrode structure 310 may be surrounded by the dielectric liner IL.

An outer surface of the expansion cavity CV may be surrounded by the cell region insulating layer 190. The dielectric liner IL and the second electrode structure 320 may extend from the through-hole H to an inner surface of the expansion cavity CV, and may be disposed on the first electrode structure 310 accommodated in the expansion cavity CV. For example, the dielectric liner IL may extend between the through-hole H and the second electrode structure 320 and may extend between the first electrode structure 310 and the second electrode structure 320. The dielectric liner IL may extend from the through-hole H to a surface of the first electrode structure 310 disposed in the expansion cavity CV, thereby covering the first electrode structure 310. The dielectric liner IL may extend from the through-hole H to the inner surface of the expansion cavity CV to cover the through-hole H and the inner surface of the expansion cavity CV. That is, the dielectric liner IL may be disposed conformally along the through-hole H, the first electrode structure 310 in the expansion cavity CV, and a surface profile of the expansion cavity CV. A portion of the dielectric liner IL may be exposed through the through-hole H.

The second electrode structure 320 may be disposed on the dielectric liner IL. The second electrode structure 320 may correspond to a surface profile of the dielectric liner IL. In an example, the second electrode structure 320 may extend from the through-hole H and may be disposed on the dielectric liner IL conformally disposed along an inner surface of expansion cavity CV and a surface profile of the first electrode structure 310 accommodated in the expansion cavity CV. Accordingly, the second electrode structure 320 may also extend from the through-hole H and may thus have a surface profile according to the inner surface of the expansion cavity CV and the surface profile of the first electrode structure 310 accommodated in the expansion cavity CV. In an example, a portion of the second electrode structure 320 may be exposed through the through-hole H. The second contact electrode 340 may be disposed on the second electrode structure 320 exposed through the through-hole H. The second contact electrode 340 may be surrounded by the passivation layer 106 in the third region R3.

The dielectric liner IL and the second electrode structure 320 may be formed in a chemical vapor deposition (CVD) process or an atomic layer deposition (ALD) process, but the present disclosure is not limited thereto.

The dielectric liner IL may include an insulating material, such as oxide and/or nitride. In another example embodiment, the dielectric liner IL may include a high-κ material. A high-κ material may refer to a dielectric material having a higher dielectric constant than a silicon oxide film (SiO₂). The high-κ material may be, for example, any one of aluminum oxide (Al₂O₃), tantalum oxide (Ta₂O₃), titanium oxide (TiO₂), yttrium oxide (Y₂O₃), zirconium oxide (ZrO₂), zirconium silicon oxide (ZrSiₓO_{y}), hafnium oxide (HfO₂), hafnium silicon oxide (HfSiₓO_{y}), lanthanum oxide (La₂O₃), lanthanum aluminum oxide (LaAlₓO_{y}), lanthanum hafnium oxide (LaHfₓO_{y}), hafnium aluminum oxide (HfAlₓO_{y}), or praseodymium oxide (Pr₂O₃). In some example embodiments, the interlayer insulating layers 120 may have a first dielectric constant, and the dielectric liner IL may have a second dielectric constant greater than the first dielectric constant of the interlayer insulating layers 120.

The second electrode structure 320 may include a conductive material, for example, at least one of tungsten (W), copper (Cu), aluminum (Al), or alloys thereof.

The first electrode structure 310, the second electrode structure 320, and the dielectric liner IL disposed between the first electrode structure 310 and the second electrode structure 320, which are disposed inside the expansion cavity CV, may be included in a capacitor.

In use, the first electrode structure 310 and the second electrode structure 320 may have different electric potentials. In an example, a contact pad 325 may be disposed on a lower surface of the first electrode structure 310. The first electrode structure 310 may receive a first electrical signal through the contact pad 325 and the first contact electrode 330. The second electrode structure 320 may receive a second electrical signal having a potential (i.e., electric potential) different from the first electrical signal through the second contact electrode 340 disposed on a portion of the second electrode structure 320 exposed through the through-hole H of the plate layer 101.

The insulating pattern 191 may extend from the through-hole H and may be disposed in the expansion cavity CV. The insulating pattern 191 may have a surface shape according to the surface profile of the first electrode structure 310 disposed in the expansion cavity CV or a surface profile of the inner surface of the expansion cavity CV. The insulating pattern 191 may include an insulating material, for example, at least one of silicon oxide, silicon nitride, or silicon carbide.

The cell upper pad 185 may be disposed below the first electrode structure 310 of the capacitor structure 300. The cell lower pad 175, the studs 180, and the cell upper pad 185 may be disposed below the cell contact plugs 170. The cell lower pad 175, the studs 180, and the cell upper pad 185 may be included in a cell interconnection structure. A cell bonding structure may be disposed below the cell lower pad 175, the studs 180, and the cell upper pad 185. The cell lower pad 175, the cell upper pad 185, and the studs 180 may include a conductive material, such as tungsten (W) or copper (Cu). However, the present disclosure is not limited thereto. As used herein, the cell lower pad 175, the studs 180, and the cell upper pad 185 may also be referred to as a cell interconnection structure or an upper interconnection structure.

The second bonding vias 195 may be disposed below the cell contact plugs 170 and the capacitor structure 300. At least a portion of the second metal bonding layers 198 may be connected to the second bonding vias 195. The second metal bonding layers 198 may be connected to the first metal bonding layers 298 of the peripheral circuit structure PERI. In another example, a portion of the second metal bonding layers 198 may not be connected to the cell interconnection structure, and may be disposed only for bonding purposes.

The second bonding vias 195 and the second metal bonding layer 198 may include a conductive material, for example, copper (Cu). The second bonding insulating layer 199 may be disposed around the second metal bonding layers 198. The second bonding insulating layer 199 may also function as a diffusion barrier for the second metal bonding layers 198, and may include, for example, at least one of SiN, SiON, SiCN, SiOC, SiOCN, or SiO.

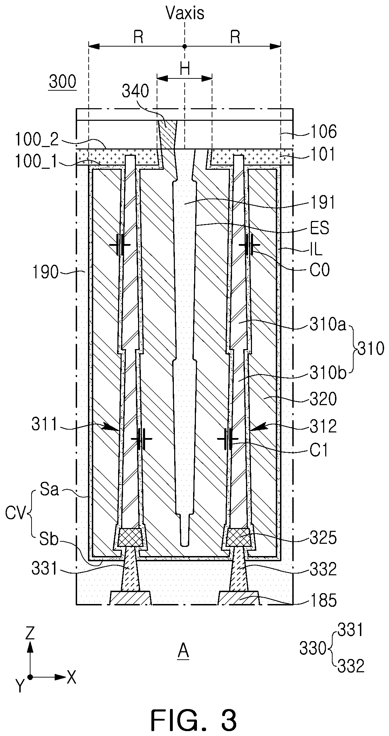

FIG. 3 is an enlarged view of region A of the semiconductor device of FIG. 2A according to example embodiments.

Referring to FIG. 3, a capacitor structure 300 may include a first electrode structure 310, a second electrode structure 320, and a dielectric liner IL accommodated in an expansion cavity CV.

The expansion cavity CV may include a side surface Sa extending in the vertical direction (Z-direction) from a first surface 100_1 of a plate layer 101 and a bottom surface Sb extending from the side surface Sa and in parallel with the horizontal direction (e.g. the horizontal plane). The side surface Sa may be spaced apart from a center of a through-hole H of the plate layer 101 by a predetermined distance R, along an imaginary axis Vaxis that passes through the center of the through-hole H and is parallel to the vertical direction (Z-direction). For example, the side surface Sa may be spaced apart from a side surface of the through-hole H (e.g., in the first direction (X-direction) and/or the second direction (Y-direction)). The bottom surface Sb may be disposed on a lower level than a lower surface of the first electrode structure 310. In an example, the bottom surface Sb may be disposed on a lower level than a contact pad 325 disposed below a first upper electrode 310b. In an example, the expansion cavity CV may be a cylindrical structure and/or a columnar structure.

The first electrode structure 310 may include a 1-1 electrode structure 311 (e.g. a first electrode, or a first electrode sub-structure) and a 1-2 electrode structure 312 (e.g. a second electrode, or a second electrode sub-structure). The 1-1 electrode structure 311 and the 1-2 electrode structure 312 may be accommodated in the expansion cavity CV. Each of the 1-1 electrode structure 311 and the 1-2 electrode structure 312 may include a first lower electrode 310a and a first upper electrode 310b, stacked from the first surface 100_1 of the plate layer 101. Although the number of electrode structures included in the first electrode structure 310 is illustrated as being two, the present disclosure is not limited thereto, and the number of electrode structures may be determined in various ways depending on the example embodiments. For example, the first electrode structure 310 may include three or more electrode structures. In the present context, a label "n-m", where n and m are numbers, may be used to distinguish different features. It will be appreciated that these terms may be used to simply distinguish a corresponding component from another, and do not necessarily limit the components in other aspect (e.g., importance or order).

The contact pad 325 and a first contact electrode 330 may be disposed below each of the first electrode structures 310. For example, the first contact electrodes 330 may include a 1-1 contact electrode 331 (e.g. a first contact) and a 1-2 contact electrode 332 (e.g. a second contact). In an example, the contact pad 325 and a 1-1 contact electrode 331 may be disposed below the 1-1 electrode structure 311. The contact pad 325 and a 1-2 contact electrode 332 may be disposed below the 1-2 electrode structure 312. In an example, the 1-1 electrode structure 311 may receive a first electrical signal through the 1-1 contact electrode 331. The 1-2 electrode structure 312 may receive the first electrical signal through the 1-2 contact electrode 332.

The dielectric liner IL may extend from the through-hole H to be on (e.g., to cover) the first electrode structure 310 protruding on the first surface 100_1 of the plate layer 101 and the expansion cavity CV. In an example, the dielectric liner IL may be on (e.g., may cover) the through-hole H, the 1-1 electrode structure 311, the 1-2 electrode structure 312, and the side surface Sa and the bottom surface Sb of the expansion cavity CV.

The second electrode structure 320 may be disposed on the dielectric liner IL. The second electrode structure 320 may be disposed according to a surface profile of the dielectric liner IL. That is, the second electrode structure 320 may extend from the through-hole H and may be on (e.g., may cover) the first electrode structure 310 protruding on the first surface 100_1 and the expansion cavity CV. The second electrode structure 320 may surround the 1-1 electrode structure 311 and the 1-2 electrode structure 312. The dielectric liner IL may extend from the through-hole H to a space between the 1-1 electrode structure 311 and the second electrode structure 320 and a space between the 1-2 electrode structure 312 and the second electrode structure 320.

A capacitor included in the first lower electrode 310a of the first electrode structure 310, the second electrode structure 320 and the dielectric liner IL may have a first capacitance C0. A capacitor included in the first upper electrode 310b of the first electrode structure 310, the second electrode structure 320 and the dielectric liner IL may have a second capacitance C1. The second capacitance C1 may be the same as the first capacitance C0, but the present disclosure is not limited thereto. In some example embodiments, the second capacitance C1 may have an electric capacity (i.e., electrical capacitance) different from the first capacitance C0.

As the second electrode structure 320 is disposed according to the surface profile of the dielectric liner IL, an internal cavity ES may be provided and/or formed inside the expansion cavity CV. For instance, the second electrode structure 320 may at least partially conform to the shape of the dielectric liner IL. An insulating pattern 191 may be disposed inside the internal cavity ES. In an example, the insulating pattern 191 may be surrounded by the dielectric liner IL and the second electrode structure 320, and may fill the through-hole H and expansion cavity CV together with the dielectric liner IL and the second electrode structure 320.

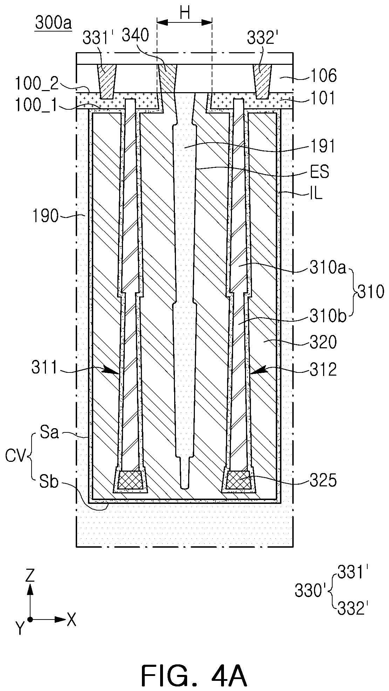

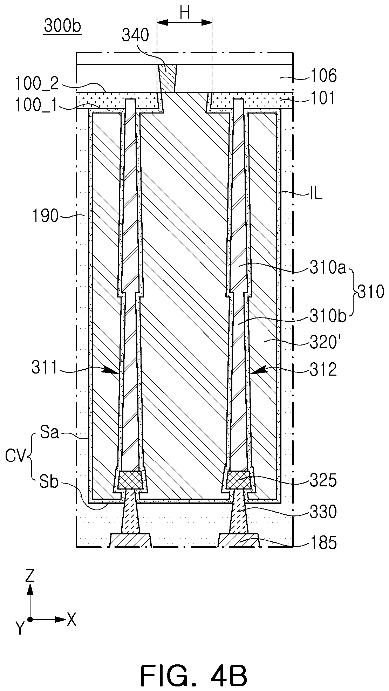

FIGS. 4A and 4B are enlarged views of the capacitor structure of FIG. 2A according to further example embodiments.

Referring to FIG. 4A, a capacitor structure 300a may include a first electrode structure 310, a second electrode structure 320, a dielectric liner IL, a first contact electrode 330' disposed on the first electrode structure 310, a second contact electrode 340 disposed on the second electrode structure 320, and an insulating pattern 191. The components excluding the first contact electrode 330' may be the same as or similar to those illustrated in FIG. 3.

The first contact electrodes 330' may be disposed on a second surface 100_2 of a plate layer 101. The first electrode structure 310 may be electrically connected to the first contact electrodes 330'. In use, the first electrode structure 310 may receive a first electrical signal through the first contact electrode 330', and the second electrode structure 320 may receive a second electrical signal having a potential (i.e., electric potential) different from the first electrical signal through the second contact electrode 340. For example, the first contact electrodes 330' may include a 1-1 contact electrode 331' (e.g. a first contact) and a 1-2 contact electrode 332' (e.g. a second contact).

A 1-1 contact electrode 331' may be disposed on the second surface 100_2 of the plate layer 101 in which an upper surface of the 1-1 electrode structure 311 is embedded. For example, the 1-1 contact electrode 331' may be electrically connected to the 1-1 electrode structure 311 through the plate layer 101. A 1-2 contact electrode 332' may be disposed on the second surface 100_2 of the plate layer 101 in which an upper surface of the 1-2 electrode structure 312 is embedded. For example, the 1-2 contact electrode 332' may be electrically connected to the 1-2 electrode structure 312 through the plate layer 101. In an example, the 1-1 contact electrode 331' and the 1-2 contact electrode 332' may be disposed on the second surface 100_2 of the plate layer 101, and may overlap each other in a horizontal direction (e.g., the X-direction). As used herein, "an element A overlaps an element B in a direction" (or similar language) means that there is at least one straight line that extends in the direction and intersects both the elements A and B.

An upper surface of the first contact electrode 330' may be disposed on the same level as an upper surface of the second contact electrode 340.

Referring to FIG. 4B, the capacitor structure 300b may include a first electrode structure 310, a second electrode structure 320', a dielectric liner IL, a first contact electrode 330 disposed below the first electrode structure 310, and a second contact electrode 340 disposed above the second electrode structure 320'. The components excluding the second electrode structure 320' may be the same as or similar to those illustrated in FIG. 3.

The second electrode structure 320' may extend from the through-hole H to completely fill a space between the dielectric liner IL and the first electrode structure 310 in the expansion cavity CV. For example, the internal cavity ES and the insulating pattern 191 shown in FIG. 3 may be omitted in the capacitor structure 300b of FIG. 4B. The through-hole H may be filled with the dielectric liner IL and the second electrode structure 320'. The second electrode structure 320' may extend from the through-hole H and may be disposed on an inner surface of the expansion cavity CV to be on (e.g., to cover) the dielectric liner IL, and may completely fill an inner space of the through-hole H and the expansion cavity CV.

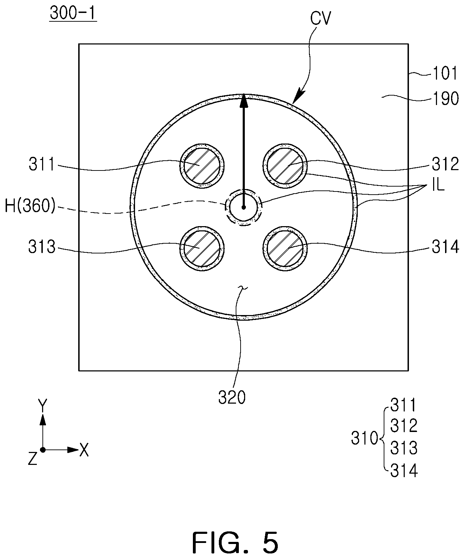

FIG. 5 is a plan view illustrating a layout of a capacitor structure according to example embodiments.

Referring to FIG. 5, a plurality of capacitors may be arranged as a unit capacitor structure 300-1 in the third region R3 of FIG. 1D.

The capacitor structure 300-1 may include first electrode structures 310, second electrode structures 320, and a dielectric liner IL disposed in an expansion cavity CV. The first electrode structures 310 may include 1-1 to 1-4 electrode structures 311 to 314 (e.g. first to fourth electrodes).

The expansion cavity CV may be a cylindrical structure having a circular bottom surface in which a radius thereof has a predetermined length based on a center of the through-hole H of the plate layer 101. The 1-1 to 1-4 electrode structures 311 to 314 may be accommodated in the expansion cavity CV. The 1-1 to 1-4 electrode structures 311 to 314 may surround the through-hole H. The dielectric liner IL may be on (e.g., may cover) an inner surface of the expansion cavity CV and the 1-1 to 1-4 electrode structures 311 to 314 accommodated in the expansion cavity CV. The second electrode structure 320 may extend from the through-hole H to be on (e.g., to cover) the dielectric liner IL inside the expansion cavity CV.

A region in which the through-hole H is disposed may be a region in which a sacrificial structure 360 (see FIG. 9A) is disposed during a manufacturing process of a capacitor structure 300-1 to be described below.

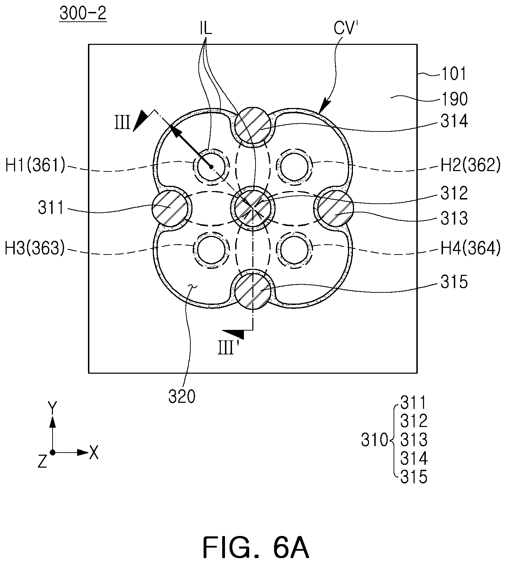

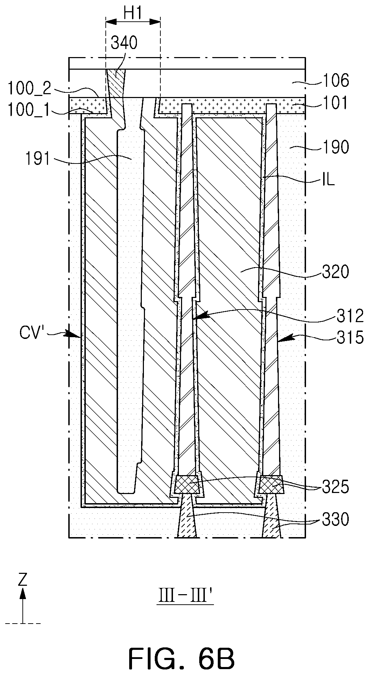

FIG. 6A is a plan view illustrating a layout of a capacitor structure according to further example embodiments. FIG. 6B is a cross-sectional view taken along line III-III' of the capacitor structure of FIG. 6A according to example embodiments.

Referring to FIGS. 6A and 6B, a plurality of capacitors structures may be arranged as a unit capacitor structure 300-2 in the third region R3 of FIG. 1D.

The capacitor structure 300-2 may include a first electrode structure 310 at least partially accommodated in an expansion cavity CV', a second electrode structure 320 accommodated in the expansion cavity CV', and a dielectric liner IL.

The first electrode structure 310 may include 1-1 to 1-5 electrode structures 311 to 315 (e.g. first to fifth electrodes). The 1-1 to 1-3 electrode structures 311 to 313 may be arranged sequentially to be spaced apart from each other in the first direction (X-direction). The 1-4 electrode structure 314, the 1-2 electrode structure 312, and the 1-5 electrode structure 315 may be arranged sequentially to be spaced apart from each other in the second direction (Y-direction).

The expansion cavity CV' may be defined by cylindrical structures, each having a circular bottom surface in which a radius thereof has a predetermined length based on a center of a corresponding through hole of through-holes H1 to H4 of a plate layer 101. The through-holes H1 to H4 of the plate layer 101 may be respectively disposed in vertices of a virtual square. When viewed in plan, the first through-hole H1 and the second through-hole H2 may be disposed above the 1-2 electrode structure 312, and the third through-hole H3 and the fourth through-hole H4 may be disposed below the 1-2 electrode structure 312.

Some portions of circles with radii having a predetermined length based on the centers of the through-holes H1 to H4 may overlap each other.

The 1-1 electrode structure 311, the 1-3 electrode structure 313, the 1-4 electrode structure 314, and the 1-5 electrode structure 315 may be partially accommodated inside the expansion cavity CV'. For example, the 1-1 electrode structure 311, the 1-3 electrode structure 313, the 1-4 electrode structure 314, and the 1-5 electrode structure 315 may be on (e.g., may be in contact with) a side surface of the expansion cavity CV'. The 1-2 electrode structure 312 may be completely accommodated in the expansion cavity CV'.

A portion of the 1-1 electrode structure 311 may be accommodated inside a cylindrical structure defined based on the center of the first through-hole H1 and a cylindrical structure defined based on the center of the third through-hole H3. A portion of the 1-3 electrode structure 313 may be accommodated inside a cylindrical structure defined based on the center of the second through-hole H2 and a cylindrical structure defined based on the center of the fourth through-hole H4. A portion of the 1-4 electrode structure 314 may be accommodated inside a cylindrical structure defined based on the center of the first through-hole H1 and a cylindrical structure defined based on the center of the second through-hole H2. A portion of the 1-5 electrode structure 315 may be accommodated inside a cylindrical structure defined based on the center of the third through-hole H3 and a cylindrical structure defined based on the center of the fourth through-hole H4.

The 1-2 electrode structure 312 accommodated in the expansion cavity CV' may be completely surrounded by the dielectric liner IL. A portion of the 1-1 electrode structure 311, the 1-3 electrode structure 313, the 1-4 electrode structure 314, and the 1-5 electrode structure 315 accommodated in the expansion cavity CV' may be surrounded by the dielectric liner IL, and the remaining portion of the 1-1 electrode structure 311, the 1-3 electrode structure 313, the 1-4 electrode structure 314, and the 1-5 electrode structure 315 that are not accommodated in the expansion cavity CV' may be in contact with a cell region insulating layer 190.

A region in which the through-holes H1 to H4 are disposed may be a region in which sacrificial structures 361 to 364 are disposed during a manufacturing process of a capacitor structure 300-2 to be described below.

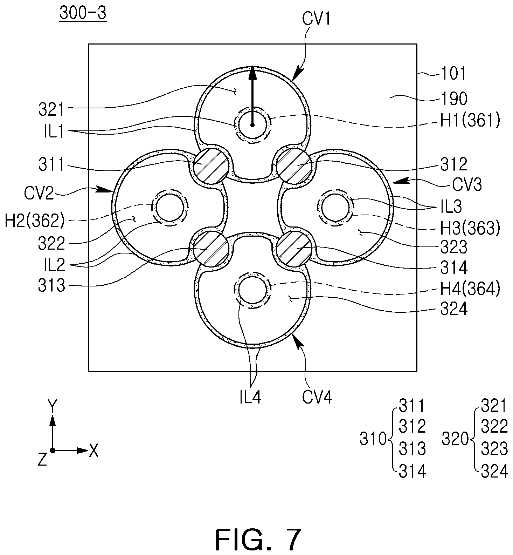

FIG. 7 is a plan view illustrating a layout of a capacitor structure according to further example embodiments.

Referring to FIG. 7, a plurality of capacitors may be arranged as a unit capacitor structure 300-3 in the third region R3 of FIG. 1D.

A capacitor structure 300-3 may include first electrode structures 310 accommodated in expansion cavities CV1 to CV4, second electrode structures 320 accommodated in the expansion cavities CV1 to CV4, and dielectric liners IL.

The expansion cavity CV may include first to fourth expansion cavities CV1 to CV4. Each of the first to fourth expansion cavities CV1 to CV4 may be a cylindrical structure having a circular bottom surface in which a radius thereof has a predetermined length based on a center of a corresponding through hole of first to fourth through-holes H1 to H4 of a plate layer 101. The first to fourth expansion cavities CV1 to CV4 may not overlap each other when viewed in plan. In other words, the first to fourth expansion cavities CV1 to CV4 may not overlap each other in the vertical direction (Z-direction).

The first electrode structure 310 may include 1-1 to 1-4 electrode structures 311 to 314. Each of the 1-1 to 1-4 electrode structures 311 to 314 may be accommodated in different first to fourth expansion cavities CV1 to CV4. In an example, a portion of the 1-1 electrode structure 311 may be accommodated in the first expansion cavity CV1, and the remainder of the 1-1 electrode structure 311 may be accommodated in the second expansion cavity CV2. For example, the 1-1 electrode structure 311 may be on (e.g., may be in contact with) a side surface of the first expansion cavity CV1 and a side surface of the second expansion cavity CV2. A portion of the 1-2 electrode structure 312 may be accommodated in the first expansion cavity CV1, and the remainder of the 1-2 electrode structure 312 may be accommodated in the third expansion cavity CV3. For example, the 1-2 electrode structure 312 may be on (e.g., may be in contact with) a side surface of the first expansion cavity CV1 and a side surface of the third expansion cavity CV3. A portion of the 1-3 electrode structure 313 may be accommodated in the second expansion cavity CV2, and the remainder of the 1-3 electrode structure 313 may be accommodated in the fourth expansion cavity CV4. For example, the 1-3 electrode structure 313 may be on (e.g., may be in contact with) a side surface of the second expansion cavity CV2 and a side surface of the fourth expansion cavity CV4. A portion of the 1-4 electrode structure 314 may be accommodated in the third expansion cavity CV3, and the remainder of the 1-4 electrode structure 314 may be accommodated in the fourth expansion cavity CV4. For example, the 1-4 electrode structure 314 may be on (e.g., may be in contact with) a side surface of the third expansion cavity CV3 and a side surface of the fourth expansion cavity CV4.

A first dielectric liner IL1 may extend from the first through-hole H1 and may be on (e.g., may cover) an inner surface of the first expansion cavity CV1, a portion of the 1-1 electrode structure 311 and a portion of the 1-2 electrode structure 312. The second electrode structure 320 may include 2-1 to 2-4 electrode structures 321 to 324. A 2-1 electrode structure 321 may be disposed on the first dielectric liner IL1.

A second dielectric liner IL2 may extend from the second through-hole H2 and may be on (e.g., may cover) an inner surface of the second expansion cavity CV2, a portion of the 1-1 electrode structure 311 and a portion of the 1-3 electrode structure 313. A 2-2 electrode structure 322 may be disposed on the second dielectric liner IL2.

A third dielectric liner IL3 may extend from the third through-hole H3 and may be on (e.g., may cover) an inner surface of the third expansion cavity CV3, a portion of the 1-2 electrode structure 312 and a portion of the 1-4 electrode structure 314. A 2-3 electrode structure 323 may be disposed on the third dielectric liner IL3.

A fourth dielectric liner IL4 may extend from the fourth through-hole H4 and may be on (e.g., may cover) an inner surface of the fourth expansion cavity CV4, a portion of the 1-3 electrode structure 313 and a portion of the 1-4 electrode structure 314. A 2-4 electrode structure 324 may be disposed on the fourth dielectric liner IL4.

The capacitor structure 300-3 may include 1-1 to 1-4 capacitors. In an example, the 1-1 electrode structure 311, the 1-2 electrode structure 312, the 2-1 electrode structure 321, and the first dielectric liner IL1 may be included in the 1-1 capacitor. The 1-1 electrode structure 311, the 1-3 electrode structure 313, the 2-2 electrode structure 322, and the second dielectric liner IL2 may be included in the 1-2 capacitor. The 1-2 electrode structure 312, the 1-4 electrode structure 314, the 2-3 electrode structure 323, and the third dielectric liner IL3 may be included in the 1-3 capacitor. The 1-3 electrode structure 313, the 1-4 electrode structure 314, the 2-4 electrode structure 324, and the fourth dielectric liner IL4 may be included in the 1-4 capacitor.

A region in which the through-holes H1 to H4 are disposed may be a region in which sacrificial structures 361 to 364 are disposed during a manufacturing process of a capacitor structure 300-3 to be described below.

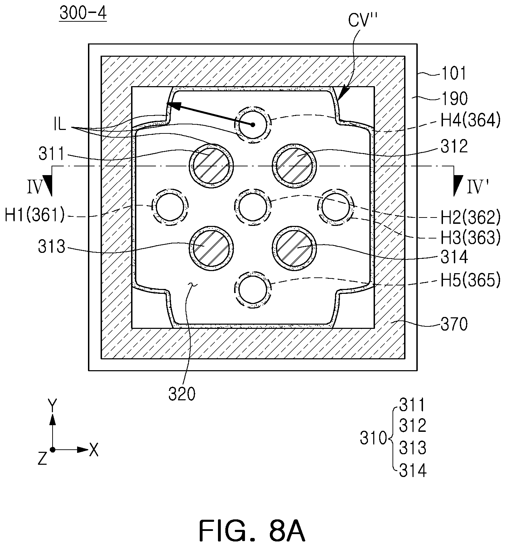

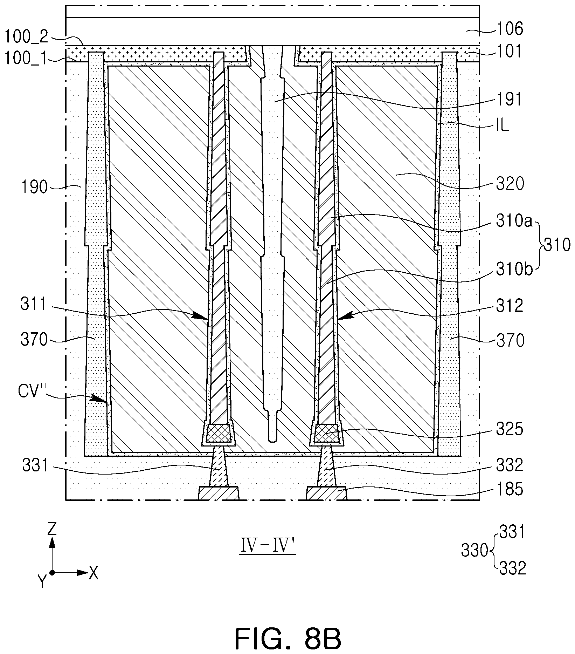

FIG. 8A is a plan view illustrating a layout of a capacitor structure according to further example embodiments. FIG. 8B is a cross-sectional view taken along line IV-IV' of the capacitor structure of FIG. 8A according to example embodiments.

Referring to FIG. 8A, a plurality of capacitors may be arranged as a unit capacitor structure 300-4 in the third region R3 of FIG. 1D.

The capacitor structure 300-4 may include a dam structure 370, first electrode structures 310 disposed in an expansion cavity CV", a second electrode structure 320 disposed in the expansion cavity CV", and a dielectric liner IL. The first electrode structures 310 may include 1-1 to 1-4 electrode structures 311 to 314 (e.g. first to fourth electrodes).

Referring to FIGS. 8A and 8B, the dam structure 370 may be disposed on a first surface 100_1 of a plate layer 101 to surround the first electrode structure 310, the second electrode structure 320, and the dielectric liner IL. The dam structure 370 may penetrate through at least a portion of a cell region insulating layer 190, and a portion of the dam structure 370 may be embedded in the plate layer 101. In an example, a height of the dam structure 370 in the vertical direction (Z-direction) may be greater than a height of the expansion cavity CV". However, the present disclosure is not limited thereto. In other example embodiments, the height of the dam structure 370 in the vertical direction (Z-direction) may be equal to the height of the expansion cavity CV". The dam structure 370 may include polysilicon, but the present disclosure is not limited thereto. In some example embodiments, the dam structure 370 may be formed in a double-layer structure including a silicon oxide layer and a poly-silicon layer.

The dam structure 370 may be a region separation structure for efficient arrangement of the dielectric liner IL and the second electrode structure 320 of the capacitor structure 300-4. The dam structure 370 may define an expanded space formed based on centers of through-holes H1 to H5 of the plate layer 101. At least a portion of the expansion cavity CV" may be in contact with the dam structure 370.

The dielectric liner IL may extend from an inner surface of the expansion cavity CV" and the first to fifth through-holes H1 to H5 to be on (e.g., to cover) first electrode structures 310 accommodated by the expansion cavity CV". The dielectric liner IL may extend from the first to fifth through-holes H1 to H5 to contact at least a portion of the dam structure 370.

FIGS. 9A to 9H are views illustrating a method of manufacturing a semiconductor device according to example embodiments.

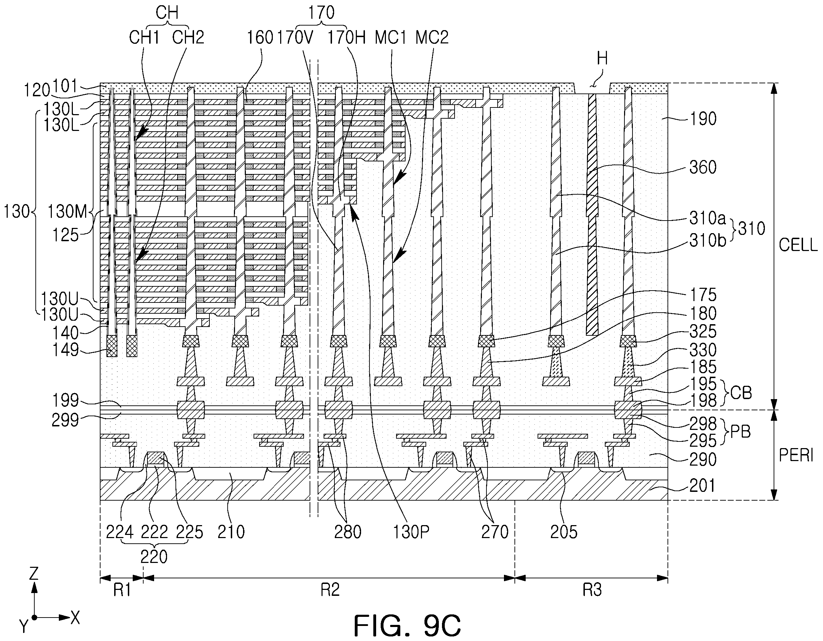

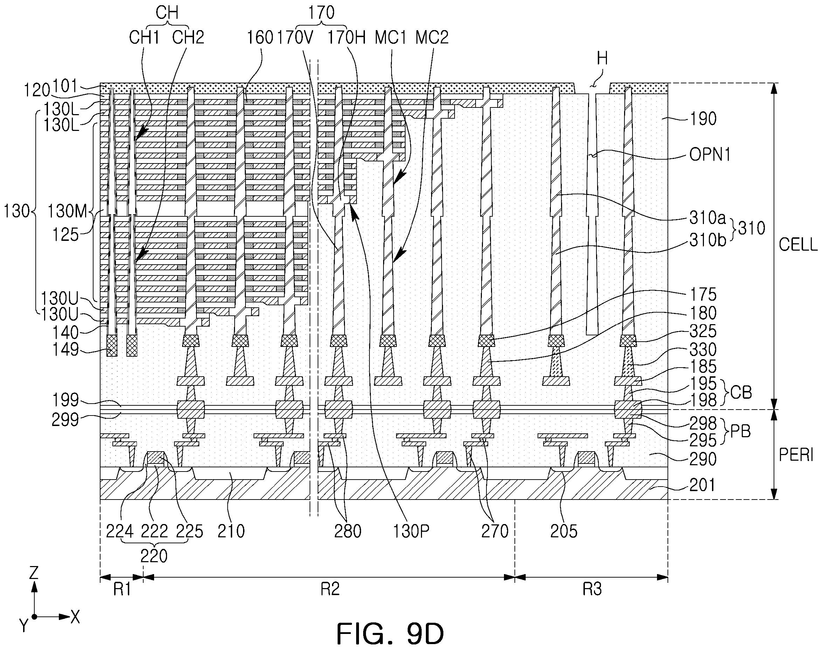

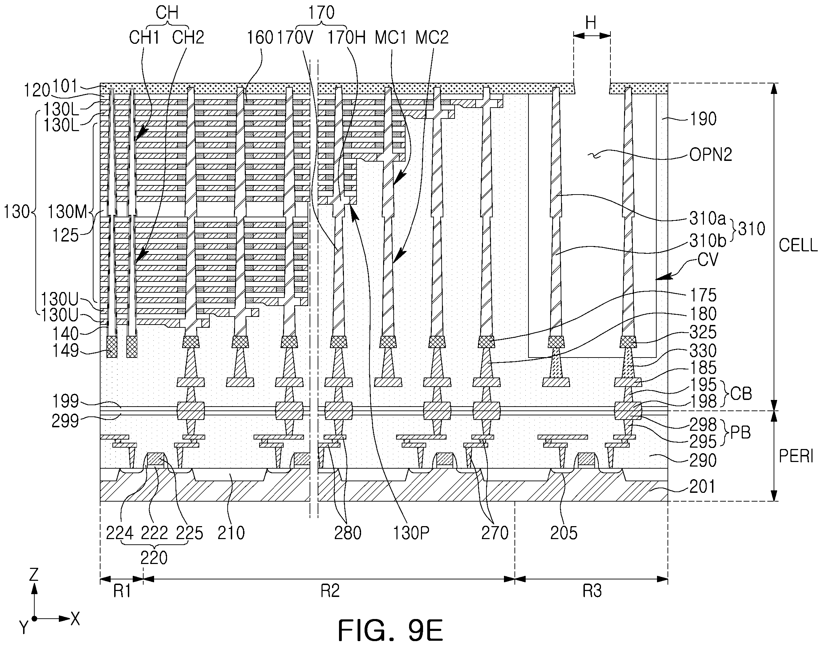

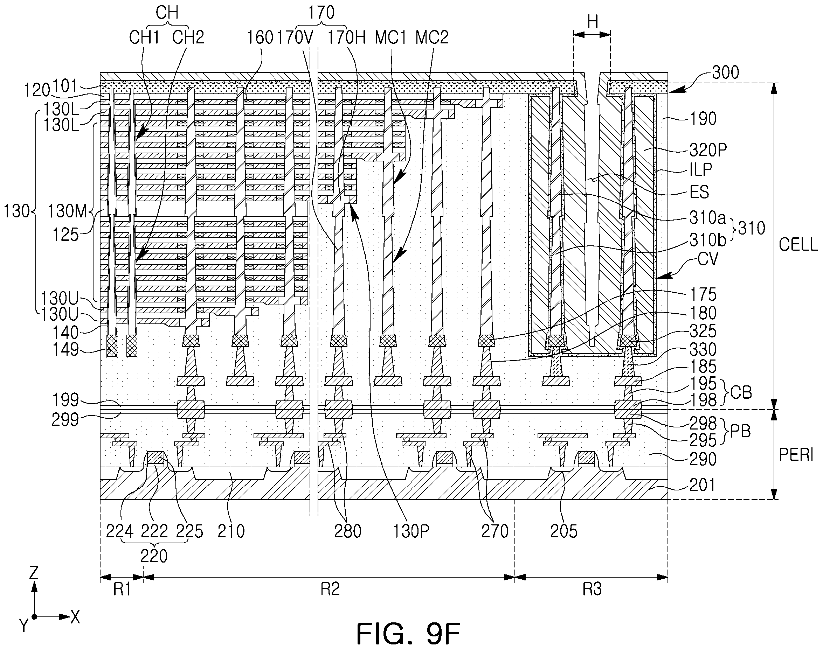

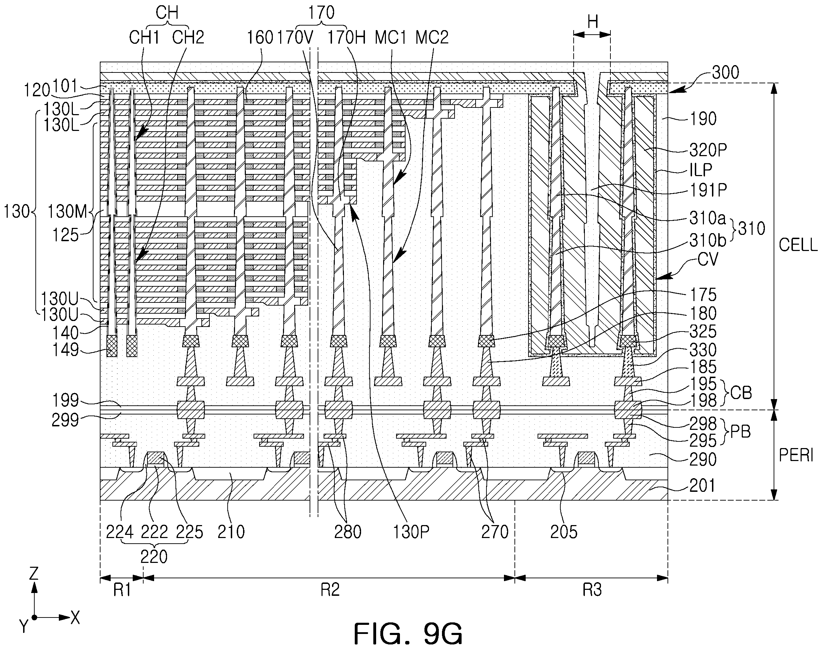

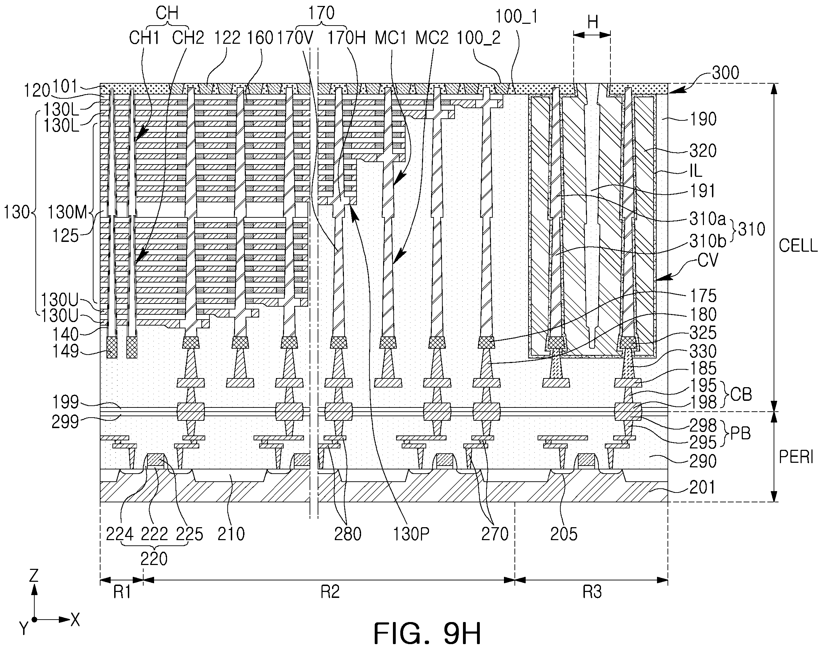

A method of manufacturing a semiconductor device according to example embodiments may include: an operation of forming a memory cell structure CELL (see FIG. 9A), an operation of forming a peripheral circuit structure PERI, bonding the memory cell structure CELL and the peripheral circuit structure PERI (see FIG. 9B), an operation of forming a through-hole H penetrating through a plate layer 101 of the memory cell structure CELL to expose a vertical sacrificial structure 360 (see FIG. 9C), an operation of forming a first opening OPN1 by removing the vertical sacrificial structure 360 (see FIG. 9D), an operation of forming an expansion cavity CV, which is a second opening OPN2, by etching a cell region insulating layer 190 using the first opening OPN1 (see FIG. 9E), an operation of forming a preliminary dielectric liner ILP and a preliminary second electrode structure 320P on an inner surface of the expansion cavity CV (see FIG. 9F), an operation of filling the preliminary insulation pattern 191P in the internal cavity ES of the expansion cavity CV (see FIG. 9G), an operation of patterning the insulating structures 122 to surround upper surfaces of cell contact plugs 170 (see FIG. 9H), and an operation of forming a second contact electrode 340 on a second electrode structure 320.

Referring to FIG. 9A, the memory cell structure CELL may be formed. The operation of forming the memory cell structure CELL may include an operation of sequentially forming gate electrodes 130, channel structures CH and cell contact plugs 170 on a base substrate 100, an operation of forming a first electrode structure 310 and a vertical sacrificial structure 360 spaced apart from the cell contact plugs 170, an operation of forming cell lower pads 175, studs 180, and cell upper pads 185 on the cell contact plugs 170, and forming a contact pad 325 and a first contact electrode 330 on the first electrode structure 310, and an operation of forming a cell bonding structure CB.

The gate electrodes 130 may be formed to extend from a first region R1 to a second region R2, and may be formed to have a step structure by repeatedly performing photolithography and etching processes on sacrificial insulating layers in the second region R2. After forming the gate electrodes 130, a cell region insulating layer 190 that is on (e.g., that covers) the gate electrodes 130 may be formed.

Channel structures CH may be formed in the first region R1 of a base substrate 100, the cell contact plugs 170 may be connected to the gate electrodes 130 in the second region R2, and a first electrode structure 310 and a vertical sacrificial structure 360 may be formed in the third region R3.

The base substrate 100 may include a semiconductor material, such as a group IV semiconductor, a group III-V compound semiconductor, or a group II-VI compound semiconductor. The base substrate 100 may be provided to control a thickness of the plate layer 101, in a process operation of removing the base substrate 100 to be described below.

The cell contact plugs 170, the first electrode structure 310, and the vertical sacrificial structure 360 may be formed by simultaneously forming contact holes using an etch stop layer or the like, and then filling the contact holes with a conductive material. However, the present disclosure is not limited thereto, and the cell contact plugs 170, the first electrode structure 310, and the vertical sacrificial structure 360 may be formed in different process operations.

The vertical sacrificial structure 360 may include a first vertical sacrificial film 360a and a second vertical sacrificial film 360b, which are stacked on an upper surface of the base substrate 100. The first vertical sacrificial film 360a may correspond to a first lower electrode 310a of the first electrode structure 310, and the second vertical sacrificial film 360b may correspond to a first upper electrode 310b of the first electrode structure 310.

The vertical sacrificial structure 360 may be a sacrificial structure that serves as a reference for etching the cell region insulating layer 190 to form an expansion cavity CV to be described below. That is, a position in which the expansion cavity CV is formed may be determined based on the vertical sacrificial structure 360.

Referring to FIG. 9B, the memory cell structure CELL and the peripheral circuit structure PERI may be bonded.

The peripheral circuit structure PERI may be already formed. The peripheral circuit structure PERI may be formed before a manufacturing process of the memory cell structure CELL, or may be formed after the manufacturing process of the memory cell structure CELL.

Circuit elements 220 of the peripheral circuit structure PERI may be formed on a substrate 201, circuit contact plugs 270 and circuit interconnection lines 280 included in a lower interconnection structure may be formed, and a peripheral bonding structure PB may be formed on the lower interconnection structure.

The peripheral circuit structure PERI and the memory cell structure CELL may be connected by bonding a second metal bonding layer 198 and a first metal bonding layer 298 with pressure. A first bonding insulating layer 299 and a second bonding insulating layer 199 may be bonded and connected with pressure. The memory cell structure CELL may be disposed upside down on the peripheral circuit structure PERI, so that the second metal bonding layer 198 of the cell bonding structure CB may be bonded to face downwardly. For example, the orientation of the memory cell structure CELL may be flipped vertically (e.g., in the vertical direction (Z-direction)) to bond the second metal bonding layer 198 to the first metal bonding layer 298. The peripheral circuit structure PERI and the memory cell structure CELL may be directly bonded without a separate adhesive material or an adhesive layer.

After the memory cell structure CELL and the peripheral circuit structure PERI are bonded, the base substrate 100 may be removed (e.g., may be partially removed) from an upper surface by a polishing process such as a grinding process and a wet etching and/or dry etching process, thereby forming a plate layer 101. A channel dielectric layer (e.g., the channel dielectric layer 145 in FIG. 2B) included in each of the channel structures CH embedded in the plate layer 101 may be removed. The channel dielectric layer may be removed by a photolithography process, a wet etching process and/or dry etching process. Accordingly, the channel layer (e.g., the channel layer 140 in FIG. 2B) may be in contact with the plate layer 101.

Referring to FIG. 9C, an upper surface of the vertical sacrificial structure 360 may be exposed by forming a through-hole H penetrating through the plate layer 101. The upper surface of the vertical sacrificial structure 360 and a portion of the cell region insulating layer 190 may be exposed through the through-hole H.

Referring to FIG. 9D, the vertical sacrificial structure 360 exposed through the through-hole H may be removed to form a first opening OPN1. The first opening OPN1 may be formed by anisotropically etching the vertical sacrificial structure 360 exposed through the through-hole H.

Referring to FIG. 9E, the cell region insulating layer 190 may be etched based on a center of the first opening OPN1, thereby forming a second opening OPN2. An expansion cavity CV may thus be formed. The second opening OPN2 may be formed by removing the cell region insulating layer 190 through an isotropic etching process based on the center of the first opening OPN1. The cell region insulating layer 190 may be etched in the vertical direction (Z-direction) and the horizontal directions (X-direction and Y-direction), respectively. In an example, a process of etching the cell region insulating layer 190 based on the center of the first opening OPN1 may be performed by a wet etching process. The second opening OPN2 may correspond to a space defining the expansion cavity CV of the capacitor structure 300 formed by removing the cell region insulating layer 190.

Referring to FIG. 9F, a preliminary dielectric liner ILP and a preliminary second electrode structure 320P may be deposited on an inner surface of the expansion cavity CV extending from the plate layer 101. The preliminary dielectric liner ILP and the preliminary second electrode structure 320P may be formed using atomic layer deposition (ALD) or chemical vapor deposition (CVD). The preliminary dielectric liner ILP may extend from the upper surface of the plate layer 101 and pass through the through-hole H, and be conformally formed on the inner surface of the expansion cavity CV. The preliminary second electrode structure 320P may be conformally formed on the preliminary dielectric liner ILP.

Referring to FIG. 9G, a preliminary insulating pattern 191P may fill an internal cavity ES (see FIG. 9F) in the expansion cavity CV. The preliminary insulating pattern 191P may extend from an upper surface of the preliminary second electrode structure 320P disposed on the upper surface of the plate layer 101 and pass through the through-hole H, and may fill the internal cavity ES. The through-hole H and the expansion cavity CV may be filled with the preliminary dielectric liner ILP, the preliminary second electrode structure 320P, and the preliminary insulating pattern 191P.

Referring to FIG. 9H, insulating structures 122 may be formed between the cell contact plugs 170 embedded in the plate layer 101. A plurality of insulating structures 122 may be formed through a patterning process on the plate layer 101 using a mask (not illustrated). The plurality of insulating structures 122 may penetrate through the plate layer 101 and may surround the cell contact plugs 170 embedded in the plate layer 101.

Before a process of forming the insulating structures 122, the preliminary dielectric liner ILP, the preliminary second electrode structure 320P, and the preliminary insulating pattern 191P on the plate layer 101 may be removed by a process such as wet etching and/or dry etching. For example, the preliminary dielectric liner ILP, the preliminary second electrode structure 320P, and the preliminary insulating pattern 191P may be replaced with the dielectric liner IL, the second electrode structure 320, and the insulating pattern 191, respectively.

Next, referring back to FIG. 2A, a passivation layer 106 may be formed on the plate layer 101, and a second contact electrode 340 may be formed on the second electrode structure 320 exposed through the through-hole H. The second contact electrode 340 may be formed by forming a via hole penetrating through the passivation layer 106 and then filling the via hole with a conductive material. Accordingly, the semiconductor device 10 of FIGS. 1A to 2B may be manufactured.

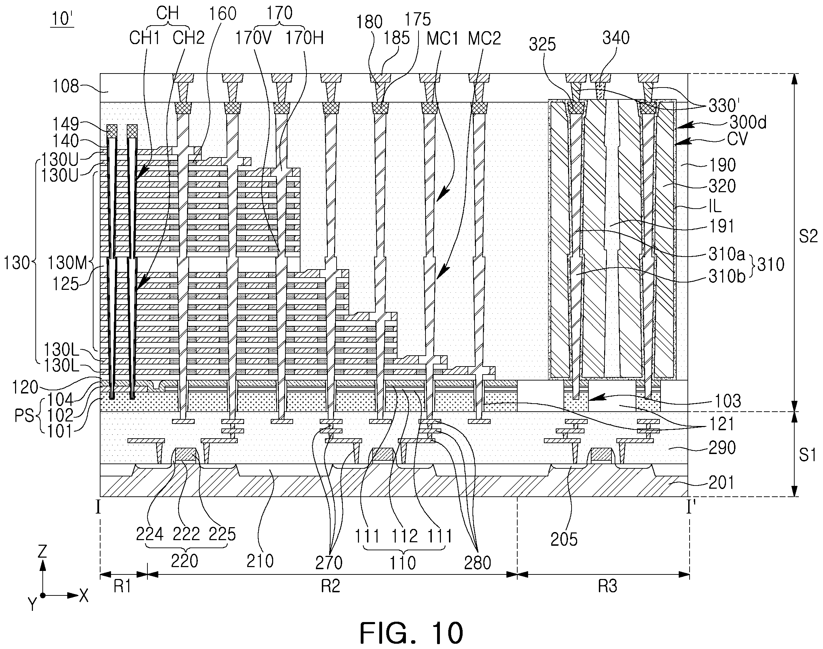

FIG. 10 is a cross-sectional view taken along line I-I' of the semiconductor device of FIG. 1D according to further example embodiments.

Referring to FIG. 10, a semiconductor device 10' may include a first semiconductor structure S1 including a substrate 201 and a second semiconductor structure S2 including a plate structure PS.

The description of the peripheral circuit structure PERI described above with reference to FIG. 2A may be applied to the first semiconductor structure S1. If there is no other explanation about the second semiconductor structure S2, the description of the memory cell structure CELL described above with reference to FIGS. 2A and 2B may be applied.

The second semiconductor structure S2 may have first, second and third regions R1, R2 and R3, and may include a plate structure PS, gate electrodes 130 stacked on a plate structure PS, interlayer insulating layers 120 alternately stacked with the gate electrodes 130, channel structures CH arranged to penetrate through a stack structure of the gate electrodes 130 in the first region R1, cell contact plugs 170 connected to the gate electrodes 130 in the second region R2 and extending vertically (e.g., in the vertical direction (Z-direction)), and a capacitor structure 300d disposed in the third region R3. The second semiconductor structure S2 may include a horizontal insulating layer 110 disposed below the gate electrodes 130, substrate insulating layers 121 disposed to penetrate through the plate structure PS, a conductive structure 103 connected to the first electrode structure 310 of the capacitor structure 300d, and a passivation layer 108 disposed on the cell region insulating layer 190.

The plate structure PS may include a plate layer 101, a first horizontal conductive layer 102, and a second horizontal conductive layer 104, which are sequentially stacked. The plate layer 101 has a shape of a plate and may function as at least a portion of a common source line of the semiconductor device 10'. The plate layer 101 may include a conductive material, for example, a semiconductor material. The plate layer 101 may further include impurities. The plate layer 101 may be provided as a polycrystalline semiconductor layer, such as a polycrystalline silicon layer, or an epitaxial layer. As used herein, the plate structure PS, the plate layer 101, and/or the conductive structure 103 may also be referred to as a stack pattern. For example, the stack pattern may include the first region R1, the second region R2, and the third region R3.

The first and second horizontal conductive layers 102 and 104 may be sequentially stacked and disposed on an upper surface of the plate layer 101. In a region in which the channel structures CH are disposed (e.g., the first region R1), the first horizontal conductive layer 102 may function as a portion of a common source line of the semiconductor device 10', for example, may function as a common source line together with the plate layer 101. The first horizontal conductive layer 102 may be directly connected to the channel layer in the channel structure CH. The first and second horizontal conductive layers 102 and 104 may include a semiconductor material, and may include, for example, polycrystalline silicon.

The horizontal insulating layer 110 may be disposed on the plate layer 101 on the same level as the first horizontal conductive layer 102. The horizontal insulating layer 110 may include first and second horizontal insulating layers 111 and 112 alternately stacked on the plate layer 101. The horizontal insulating layer 110 may be layers that remain after a portion of the horizontal insulating layer 110 is replaced with the first horizontal conductive layer 102 during a manufacturing process of the semiconductor device 10'. The horizontal insulating layer 110 may include silicon oxide, silicon nitride, silicon carbide, or silicon oxynitride. The first horizontal insulating layers 111 and the second horizontal insulating layers 112 may include different insulating materials.

The substrate insulating layers 121 may be disposed to penetrate through the plate layer 101, the horizontal insulating layer 110, and the second horizontal conductive layer 104. The substrate insulating layer 121 may include an insulating material, for example, silicon oxide, silicon nitride, silicon carbide, or silicon oxynitride.

The cell contact plugs 170 may penetrate through the gate electrodes 130 below the contact regions 130P and may penetrate through the second horizontal conductive layer 104, the horizontal insulating layer 110 and the plate layer 101, and may thus be connected to circuit contact plugs 270 and circuit interconnection lines 280 in the first semiconductor structure S1.

The cell contact plugs 170 may be spaced apart from the gate electrodes 130 below the contact regions 130P by the contact insulating layers 160. The cell contact plugs 170 may be spaced apart from the plate layer 101, a horizontal insulating layer 110, and the second horizontal conductive layer 104 by the substrate insulating layers 121. For example, upper surfaces of the cell contact plugs 170 may be coplanar with an upper surface of the first electrode structure 310 (e.g., may be coplanar with an upper surface of the first lower electrode 310a).

A passivation layer 108 may be disposed on the cell region insulating layer 190, and may surround studs 180, cell upper pads 185, a first contact electrode 330' and a second contact electrode 340. The passivation layer 108 may include an insulating material, for example, at least one of silicon oxide, silicon nitride, or silicon carbide.

If there is no other explanation below on the capacitor structure 300d, the description of the capacitor structure 300 described above with reference to FIGS. 2A and 3 may be applied.

The capacitor structure 300d may include a first electrode structure 310, a second electrode structure 320, a dielectric liner IL, a first contact electrode 330' disposed above the first electrode structure 310, a second contact electrode 340 disposed on the second electrode structure 320, and an insulating pattern 191.

The first electrode structure 310 may extend in the vertical direction (Z-direction) on the plate structure PS (e.g., on the conductive structure 103). The first electrode structure 310 may be disposed on the third region R3 to be spaced apart from the cell contact plugs 170 in the first direction (X-direction). A lower surface of a first upper electrode 310b may be embedded in the conductive structure 103. The conductive structure 103 may have the same structure as the plate structure PS. The substrate insulating layers 121 may be disposed between the conductive structure 103 and the plate structure PS.

The dielectric liner IL may be on (e.g., may cover) the first electrode structures 310 in the expansion cavity CV and an inner surface of the expansion cavity CV. The second electrode structure 320 may be disposed on the dielectric liner IL.

The first contact electrode 330' may be disposed on the first electrode structure 310. A second contact electrode 340 may be disposed on the second electrode structure 320. The first contact electrode 330' and the second contact electrode 340 may be surrounded by the passivation layer 108.

The insulating pattern 191 may penetrate the expansion cavity CV in the vertical direction (Z-direction). However, the present disclosure is not limited thereto, and the insulating pattern 191 may penetrate through at least a portion of the expansion cavity CV.

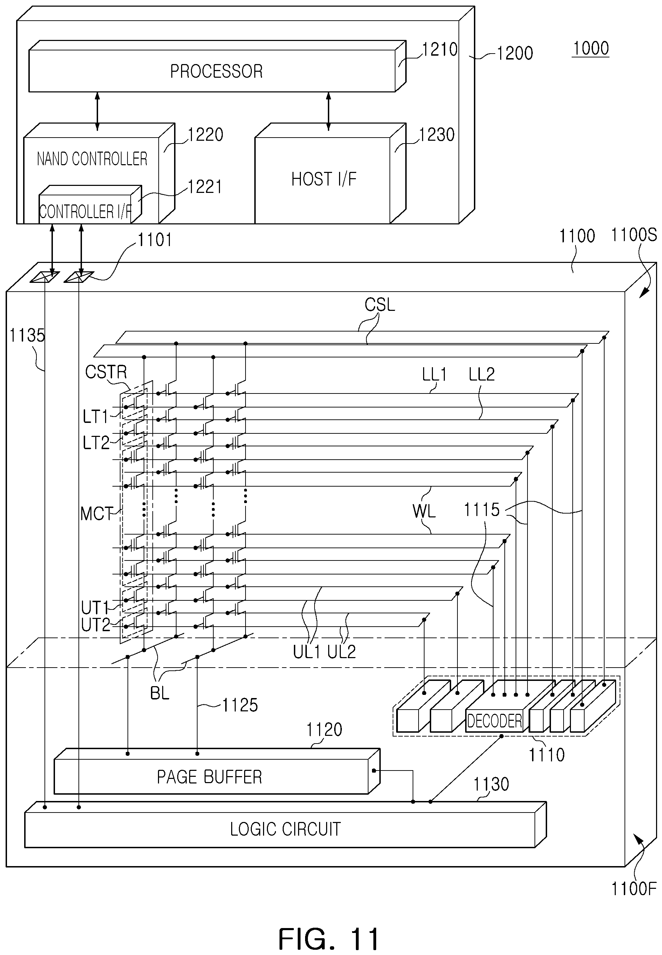

FIG. 11 is a view schematically illustrating a data storage system including a semiconductor device according to example embodiments of the present disclosure.

Referring to FIG. 11, a data storage system 1000 may include a semiconductor device 1100 and a controller 1200 electrically connected to the semiconductor device 1100. The data storage system 1000 may be a storage device including one or a plurality of semiconductor devices 1100 or an electronic device including a storage device. For example, the data storage system 1000 may be a solid state drive device (SSD) device, a Universal Serial Bus (USB), a computing system, a medical device, or a communication device, including one or a plurality of semiconductor devices 1100.

The semiconductor device 1100 may be a non-volatile memory device, and may be, for example, a NAND flash memory device described above with reference to FIGS. 1A to 2B. For example, the semiconductor device 1100 may include the semiconductor device 10 or the semiconductor device 10' described above. As used herein, the semiconductor device 1100 may also be referred to as a semiconductor storage device. The semiconductor device 1100 may include a first semiconductor structure 1100F and a second semiconductor structure 1100S on the first semiconductor structure 1100F. In some example embodiments, the first semiconductor structure 1100F may be disposed next to the second semiconductor structure 1100S. The first semiconductor structure 1100F may be a peripheral circuit structure including a decoder circuit 1110, a page buffer 1120, and a logic circuit 1130. The second semiconductor structure 1100S may be a memory cell structure including a bit line BL, a common source line CSL, word lines WL, first and second gate upper lines UL1 and UL2, first and second gate lower lines LL1 and LL2, and memory cell strings CSTR between the bit line BL and the common source line CSL. As used herein, the decoder circuit 1110, the page buffer 1120, and/or the logic circuit 1130 may also be referred to as circuit elements.

In the second semiconductor structure 1100S, each of the memory cell strings CSTR may include lower transistors LT1 and LT2 adjacent to a common source line CSL, upper transistors UT1 and UT2 adjacent to the bit line BL, and a plurality of memory cell transistors MCT disposed between the lower transistors LT1 and LT2 and the upper transistors UT1 and UT2. The number of lower transistors LT1 and LT2 and upper transistors UT1 and UT2 may be variously modified depending on example embodiments.

According to example embodiments, the upper transistors UT1 and UT2 may include string select transistors, and the lower transistors LT1 and LT2 may include a ground selection transistor. The gate lower lines LL1 and LL2 may be gate electrodes of the lower transistors LT1 and LT2, respectively. The word lines WL may be gate electrodes of memory cell transistors MCT, and the gate upper lines UL1 and UL2 may be gate electrodes of the upper transistors UT1 and UT2, respectively.

According to example embodiments, the lower transistors LT1 and LT2 may include a lower erase control transistor LT1 and a ground selection transistor LT2 connected in series. The upper transistors UT1 and UT2 may include a string select transistor UT1 and an upper erase control transistor UT2 connected in series. At least one of the lower erase control transistor LT1 or the upper erase control transistor UT2 may be used in an erase operation of deleting data stored in memory cell transistors MCT using a gate-induced drain leakage (GIDL) phenomenon.

The common source line CSL, the first and second gate lower lines LL1 and LL2, the word lines WL and the first and second gate upper lines UL1 and UL2 may be electrically connected to the decoder circuit 1110 through first connection interconnections 1115 extending from the first semiconductor structure 1100F to the second semiconductor structure 1100S. The bit lines BL may be electrically connected to the page buffer 1120 through second connection interconnections 1125 extending from the first semiconductor structure 1100F to the second semiconductor structure 1100S.

In the first semiconductor structure 1100F, the decoder circuit 1110 and the page buffer 1120 may perform a control operation on at least one selected memory cell transistor, among the plurality of memory cell transistors MCT. The decoder circuit 1110 and the page buffer 1120 may be controlled by the logic circuit 1130. The semiconductor device 1100 may communicate with the controller 1200 through an input/output pad 1101 electrically connected to the logic circuit 1130. The input/output pad 1101 may be electrically connected to the logic circuit 1130 through an input/output connection interconnection 1135 extending from the first semiconductor structure 1100F to the second semiconductor structure 1100S. As used herein, the first connection interconnections 1115, the second connection interconnections 1125, and/or the input/output connection interconnection 1135 may also be referred to as circuit interconnections.

The controller 1200 may include a processor 1210, a NAND controller 1220, and a host interface 1230. According to example embodiments, the data storage system 1000 may include a plurality of semiconductor devices 1100, and in this case, the controller 1200 may control a plurality of semiconductor devices 1100.

The processor 1210 may control an overall operation of the data storage system 1000, including the controller 1200. The processor 1210 may operate according to predetermined firmware, and may control the NAND controller 1220 to access the semiconductor device 1100. The NAND controller 1220 may include a NAND interface 1221 configured to process communication with the semiconductor device 1100. Through the NAND interface 1221, control commands for controlling the semiconductor device 1100, data to be recorded in the memory cell transistors MCT of the semiconductor device 1100, and data to be read from the memory cell transistors MCT of the semiconductor device 1100 may be transmitted. The host interface 1230 may provide a communication function between the data storage system 1000 and an external host. When receiving the control commands from the external host through the host interface 1230, the processor 1210 may control the semiconductor device 1100 in response to the control command.

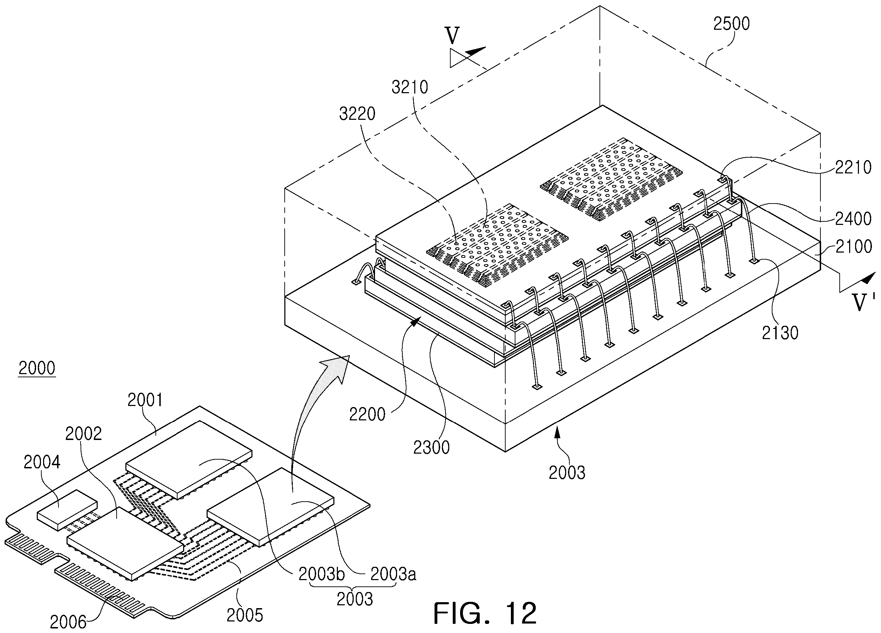

FIG. 12 is a perspective view schematically illustrating a data storage system including a semiconductor device according to example embodiments of the present disclosure.

Referring to FIG. 12, a data storage system 2000 according to example embodiments of the present disclosure may include a main board 2001, a controller 2002 mounted on the main board 2001, one or more semiconductor packages 2003, and a DRAM 2004. The semiconductor package 2003 and the DRAM 2004 may be connected to the controller 2002 through interconnection patterns 2005 formed on the main board 2001.

The main board 2001 may include a connector 2006 including a plurality of pins coupled to the external host. The number and arrangement of the plurality of pins in the connector 2006 may vary, depending on the communication interface between the data storage system 2000 and the external host. In example embodiments, the data storage system 2000 may communicate with the external host through one of the interfaces of M-Phy and the like, for Universal Serial Bus (USB), Peripheral Component Interconnect Express (PCI-Express), Serial Advanced Technology Attachment (SATA) and Universal Flash Storage (UFS). In example embodiments, the data storage system 2000 may operate with power supplied from the external host through the connector 2006. The data storage system 2000 may further include a Power Management Integrated Circuit (PMIC) configured to distribute power supplied from the external host to the controller 2002 and the semiconductor package 2003.

The controller 2002 may record data in the semiconductor package 2003 or read data from the semiconductor package 2003, and may improve the operating speed of data storage system 2000.

The DRAM 2004 may be a buffer memory to alleviate a speed difference between the semiconductor package 2003 as a data storage space, and the external host. The DRAM 2004 included in the data storage system 2000 may also operate as a type of cache memory, and may provide a space for temporarily storing data in a control operation for the semiconductor package 2003. When the data storage system 2000 includes the DRAM 2004, the controller 2002 may further include a DRAM controller for controlling the DRAM 2004 in addition to the NAND controller for controlling the semiconductor package 2003.

The semiconductor package 2003 may include first and second semiconductor packages 2003a and 2003b spaced apart from each other. Each of the first and second semiconductor packages 2003a and 2003b may include a plurality of semiconductor chips 2200. Each of the first and second semiconductor packages 2003a and 2003b may include a package substrate 2100, semiconductor chips 2200 on the package substrate 2100, adhesive layers 2300 disposed on a lower surface of each of the semiconductor chips 2200, a connection structure 2400 electrically connecting the semiconductor chips 2200 and the package substrate 2100, and a molding layer 2500 on (e.g., covering) the semiconductor chips 2200 and the connection structure 2400 on the package substrate 2100.

The package substrate 2100 may be a printed circuit board (PCB) including package upper pads 2130. Each of the semiconductor chips 2200 may include an input/output pad 2210. The input/output pad 2210 may correspond to the input/output pad 1101 of FIG. 11. Each of the semiconductor chips 2200 may include gate stack structures 3210 and channel structures 3220. Each of the semiconductor chips 2200 may include the semiconductor device described above with reference to FIGS. 1A to 2B and FIG. 10. For example, each of the semiconductor chips 2200 may include the semiconductor device 10 or the semiconductor device 10' described above.

In example embodiments, the connection structure 2400 may be a bonding wire electrically connecting the input/output pad 2210 and the package upper pads 2130. Accordingly, in each of the first and second semiconductor packages 2003a and 2003b, the semiconductor chips 2200 may be electrically connected to each other using a bonding wire method and may be electrically connected to the package upper pads 2130 of the package substrate 2100. In other example embodiments, in each of the first and second semiconductor packages 2003a and 2003b, the semiconductor chips 2200 may be electrically connected to each other by a connection structure including a Through-Silicon Via (TSV) instead of the connection structure 2400 of a bonding wire type.

In example embodiments, the controller 2002 and the semiconductor chips 2200 may be included in one package. In some example embodiments, the controller 2002 and the semiconductor chips 2200 may be mounted on a separate interposer board different from the main board 2001, and the controller 2002 and the semiconductor chips 2200 may be connected to each other by an interconnection formed on the interposer board.

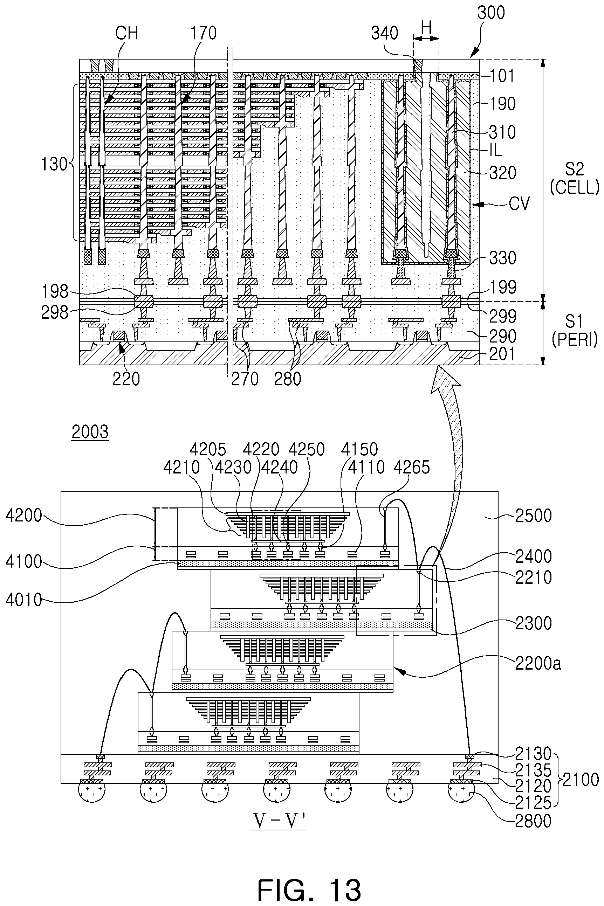

FIG. 13 is a cross-sectional view schematically illustrating a semiconductor package according to example embodiments of the present disclosure. In particular, FIG. 13 illustrates an example embodiment of the semiconductor package 2003 of FIG. 12 and conceptually illustrates a region in which the semiconductor package 2003 of FIG. 12 is cut along line V-V'.

Referring to FIG. 13, in a semiconductor package 2003 (e.g., in the first semiconductor package 2003a of FIG. 12), a package substrate 2100 may be a printed circuit board. The package substrate 2100 may include a package substrate body portion 2120, package upper pads 2130 disposed on an upper surface of the package substrate body portion 2120, bottom pads 2125 disposed on a lower surface of the package substrate body portion 2120 or exposed through the lower surface thereof, and internal interconnections 2135 electrically connecting the upper pads 2130 and the lower pads 2125 inside the package substrate body portion 2120. The upper pads 2130 may be electrically connected to the connection structures 2400. The lower pads 2125 may be connected to the interconnection patterns 2005 of a main board 2001 of the data storage system 2000 as illustrated in FIG. 12 through conductive connectors 2800.

In the semiconductor package 2003, each of the semiconductor chips 2200a may include a semiconductor substrate 4010, a first semiconductor structure 4100 on the semiconductor substrate 4010, and a second semiconductor structure 4200 bonded to the first semiconductor structure 4100 on the first semiconductor structure 4100 using a wafer bonding method.

The first semiconductor structure 4100 may include a peripheral circuit region including a peripheral interconnection 4110 and a lower bonding structure 4150. The second semiconductor structure 4200 may include a common source line 4205, a gate stack structure 4210 between the common source line 4205 and the first semiconductor structure 4100, channel structures 4220 and separation structures 4230 penetrating through the gate stack structure 4210, and an upper bonding structure 4250 electrically connected to the channel structures 4220 and the word lines of the gate stack structure 4210, respectively. For example, the upper bonding structure 4250 may be electrically connected to the channel structures 4220 and word lines, respectively, through the bit lines 4240 electrically connected to the channel structures 4220 and the cell contact plugs 170 (e.g., see FIG. 2A) electrically connected to the word lines. The lower bonding structure 4150 of the first semiconductor structure 4100 and the upper bonding structure 4250 of the second semiconductor structure 4200 may be in contact with and bonded to each other. The bonded portions of the lower bonding structure 4150 and the upper bonding structure 4250 may be formed of, for example, copper (Cu).

The second semiconductor structure 4200 may further include a capacitor structure 300, as illustrated in the enlarged view. The capacitor structure 300 may be spaced apart from the channel structures CH and the cell contact plugs 170 and may be disposed at an outside of the second semiconductor structure 4200. The capacitor structure 300 may include a first electrode structure 310 which is a cylindrical structure at least partially accommodated by an expansion cavity CV and extending in the vertical direction, a dielectric liner IL on (e.g., covering) an inner surface of the expansion cavity CV and the first electrode structure 310, and a second electrode structure 320 on the dielectric liner IL.

Each of the semiconductor chips 2200a may further include an input/output pad 2210 and an input/output connection interconnection 4265 below the input/output pad 2210. The input/output connection interconnection 4265 may be electrically connected to a portion of the upper bonding structures 4250. The input/output pad 2210 may be a region including a conductive pad.

The semiconductor chips 2200a of FIG. 13 may be electrically connected to each other by the connection structures 2400 in the form of a bonding wire. However, in other example embodiments, semiconductor chips inside one semiconductor package, such as the semiconductor chips 2200a of FIG. 13, may be electrically connected to each other by a connection structure including the Through-Silicon Via (TSV).

Embodiments are set out in the following Clauses:
Clause 1. A semiconductor device, comprising:
   a first semiconductor structure including a substrate, circuit elements on the substrate, a lower interconnection structure electrically connected to the circuit elements, and a first metal bonding layer on the circuit elements and the lower interconnection structure; and
   a second semiconductor structure including a plate layer including at least one through-hole, gate electrodes stacked and spaced apart from each other in a direction, perpendicular to a lower surface of the plate layer, channel structures penetrating through the gate electrodes and extending in the perpendicular direction, a capacitor structure spaced apart from the channel structures on the lower surface of the plate layer, and a second metal bonding layer disposed below the channel structures and below the capacitor structure and bonded to the first metal bonding layer,
   wherein the capacitor structure includes:
      a first electrode structure disposed on the lower surface of the plate layer;
      a second electrode structure extending from the at least one through-hole, surrounding at least a portion of the first electrode structure, and partially exposed through the at least one through-hole; and
      a dielectric liner extending from between the at least one through-hole and the second electrode structure to between the first electrode structure and the second electrode structure.
Clause 2. The semiconductor device of Clause 1, further comprising an expansion cavity configured to overlap the at least one through-hole on the lower surface of the plate layer and configured to accommodate at least a portion of the first electrode structure,
   wherein the dielectric liner and the second electrode structure extend from the at least one through-hole and are sequentially disposed on an inner surface of the expansion cavity.
Clause 3. The semiconductor device of Clause 2, wherein the expansion cavity has a shape of a cylinder having a side surface spaced from a center of the at least one through-hole on the lower surface of the plate layer by a first distance along an imaginary axis that passes through the center and is parallel to the perpendicular direction.
Clause 4. The semiconductor device of Clause 2 or Clause 3, further comprising an insulating pattern extending from the at least one through-hole and surrounded by the second electrode structure inside the expansion cavity.
Clause 5. The semiconductor device of any of Clauses 2-4, wherein the second electrode structure extends from the at least one through-hole and completely fills the expansion cavity.
Clause 6. The semiconductor device of any of Clauses 2-5, wherein the first electrode structure is disposed in the expansion cavity.
Clause 7. The semiconductor device of any of Clauses 2-6, wherein a portion of the first electrode structure is disposed in a boundary of the expansion cavity when viewed in plan.
Clause 8. The semiconductor device of any of Clauses 2-7, wherein the expansion cavity includes a side surface in parallel with the perpendicular direction and a bottom surface extending from the side surface and in parallel with a horizontal direction, intersecting the perpendicular direction, and
   the bottom surface is disposed on a lower level than a lower surface of the first electrode structure.
Clause 9. The semiconductor device of any preceding Clause, further comprising a cell region insulating layer disposed on the lower surface of the plate layer to cover the gate electrodes,
   wherein the capacitor structure further includes a dam structure surrounding the first electrode structure, the second electrode structure and the dielectric liner on the lower surface of the plate layer, and penetrating the cell region insulating layer in the perpendicular direction.
Clause 10. The semiconductor device of Clause 9, wherein the dielectric liner extends from between the first electrode structure and the second electrode structure to between at least a portion of the dam structure and the second electrode structure.
Clause 11. The semiconductor device of any preceding Clause, further comprising:
   a first contact electrode disposed on a lower surface of the first electrode structure and connected to the first electrode structure; and
   a second contact electrode disposed on the second electrode structure exposed through the at least one through-hole and connected to the second electrode structure.
Clause 12. The semiconductor device of Clause 11, wherein a portion of the first contact electrode adjacent to the lower surface of the first electrode structure is surrounded by the dielectric liner.
Clause 13. The semiconductor device of any of Clauses 1-10, further comprising:
   a first contact electrode disposed on the upper surface of the plate layer and connected to the first electrode structure; and
   a second contact electrode disposed on the second electrode structure exposed through the through-hole and connected to the second electrode structure.
Clause 14. The semiconductor device of any preceding Clause, wherein the first electrode structure includes a cylindrical conductive structure in which a width thereof becomes narrower toward the lower surface of the plate layer.
Clause 15. A semiconductor device, comprising:
   a stack pattern including a cell array region, a cell contact region, and a peripheral region sequentially arranged in a first direction;
   a stack structure extending on the cell array region and the cell contact region of the stack pattern, wherein the stack structure includes interlayer insulating layers and gate electrodes alternately arranged in a vertical direction intersecting the first direction;
   a channel structure extending in the vertical direction through the stack structure on the cell array region;
   contact plugs extending through ones of the gate electrodes and ones of the interlayer insulating layers on the cell contact region; and
   a capacitor structure on the peripheral region of the stack pattern and including an expansion cavity,
   wherein the capacitor structure comprises:
      a first electrode structure on the stack pattern and in the expansion cavity;
      a dielectric liner on the first electrode structure in the expansion cavity and on an inner surface of the expansion cavity; and
      a second electrode structure on the dielectric liner.
Clause 16. The semiconductor device of Clause 15, wherein the stack pattern includes at least one through-hole that overlaps the expansion cavity in the vertical direction.
Clause 17. The semiconductor device of Clause 15 or Clause 16, wherein the first electrode structure includes a first lower electrode on the stack pattern and a first upper electrode on the first lower electrode, and
   wherein each of the first lower electrode and the first upper electrode has a cylindrical shape with a width that becomes narrower toward the stack pattern.
Clause 18. The semiconductor device of Clause 17, wherein an upper surface of each of the contact plugs is coplanar with an upper surface of the first upper electrode.
Clause 19. The semiconductor device of any of Clauses 15-18, wherein the interlayer insulating layers have a first dielectric constant, and
   wherein the dielectric liner has a second dielectric constant greater than the first dielectric constant.
Clause 20. A data storage system, comprising:
   a semiconductor storage device including a first semiconductor structure comprising circuit elements and circuit interconnections electrically connected to the circuit elements, a second semiconductor structure on a surface of the first semiconductor structure and comprising a first region, a second region, and a third region, and an input/output pad electrically connected to the circuit elements; and
   a controller electrically connected to the semiconductor storage device through the input/output pad and configured to control the semiconductor storage device,
   wherein the second semiconductor structure comprises:
      a plate layer including at least one through-hole on the third region and including a front surface and a rear surface opposing each other;
      gate electrodes stacked and spaced apart from each other in a first direction perpendicular to the rear surface of the plate layer, each of the gate electrodes including a pad region;
      a channel structure extending in the first direction through the gate electrodes in the first region;
      contact plugs extending in the first direction through the pad region of respective ones of the gate electrodes in the second region, the contact plugs electrically connecting the respective ones of the gate electrodes to a portion of the circuit interconnections; and
      a capacitor structure that is on the rear surface of the plate layer in the third region and is overlapped by the at least one through-hole in the first direction,
      wherein the capacitor structure comprises:
         a first electrode structure that extends in the first direction on the rear surface of the plate layer;
         a second electrode structure that surrounds at least a portion of the first electrode structure and extends in the at least one through-hole; and
         a dielectric liner that extends between the at least one through-hole and the second electrode structure and between the first electrode structure and the second electrode structure, and
         wherein the second electrode structure and the dielectric liner conformally extend along at least a portion of the first electrode structure.
Clause 21. A semiconductor device, comprising:
   a stack pattern including a cell array region, a cell contact region, and a peripheral region sequentially arranged in a first direction;
   a stack structure extending from the cell array region to the cell contact region on the stack pattern, wherein in the stack structure, interlayer insulating layers and gate electrodes are arranged alternately in a vertical direction;
   a channel structure penetrating through the stack structure in the cell array region and extending in a vertical direction, intersecting the first direction;
   contact plugs penetrating through the gate electrodes and the interlayer insulating layer in the cell contact region; and
   a capacitor structure disposed on the stack pattern in the peripheral region and including an expansion cavity,
   wherein the capacitor structure includes:
      a first electrode structure disposed on an upper surface of the stack pattern and at least partially accommodated by the expansion cavity;
      a dielectric liner configured to cover the first electrode structure disposed inside the expansion cavity and the expansion cavity; and
      a second electrode structure disposed on the dielectric liner.
Clause 22. The semiconductor device of Clause 21, wherein the stack pattern includes at least one through-hole overlapping the expansion cavity when viewed in plan.
Clause 23. The semiconductor device of Clause 21 or Clause 22, wherein the first electrode structure includes a first lower electrode disposed on the stack pattern and a first upper electrode disposed on the first lower electrode, and
   each of the first lower electrode and the first upper electrode has a cylindrical shape in which a width thereof becomes narrower toward the upper surface of the stack pattern.
Clause 24. The semiconductor device of Clause 23, wherein an upper surface of each of the contact plugs is disposed on the same level as an upper surface of the first upper electrode.
Clause 25. The semiconductor device of any of Clauses 21-24, wherein the interlayer insulating layer has a first dielectric constant, and
   the dielectric liner has a second dielectric constant greater than the first dielectric constant.
Clause 26. A data storage system, comprising:
   a semiconductor storage device including a first semiconductor structure including circuit elements and circuit interconnections electrically connected to the circuit elements, a second semiconductor structure disposed on one surface of the first semiconductor structure and including a first region, a second region and a third region, and an input/output pad electrically connected to the circuit elements; and
   a controller electrically connected to the semiconductor storage device through the input/output pad and configured to control the semiconductor storage device,
   wherein the second semiconductor structure includes:
      a plate layer including at least one through-hole on the third region and including a front surface and a rear surface opposing the front surface;
      gate electrodes stacked and spaced apart from each other in a direction, perpendicular to the rear surface of the plate layer, each of which includes a pad region in which an upper surface thereof is exposed upwardly;
      a channel structure penetrating through the gate electrodes in the first region and extending in the perpendicular direction;
      contact plugs penetrating through pad regions of each of the gate electrodes in the second region, extending in the perpendicular direction, and respectively connecting the gate electrodes to a portion of the circuit interconnections; and
      a capacitor structure disposed on the rear surface of the plate layer in the third region and configured to overlap the through-hole when viewed in plan,
      wherein the capacitor structure includes:
         a first electrode structure extending on the rear surface of the plate layer in the perpendicular direction;
         a second electrode structure extending from the at least one through-hole, surrounding at least a portion of the first electrode structure and partially exposed through the through-hole, and
         a dielectric liner extending from between the at least one through-hole and the second electrode structure to between the first electrode structure and the second electrode structure, and
         wherein the second electrode structure and the dielectric liner conformally cover at least a portion of the first electrode structure.

While example embodiments have been shown and described above, it will be apparent to those skilled in the art that modifications and variations could be made without departing from the scope of the present disclosure as defined by the appended claims.

As used herein, the terms "comprises", "comprising", "includes", "including", "has", "having" and any other variations thereof specify the presence of the stated features, steps, operations, elements, components, and/or groups but do not preclude the presence or addition of one or more other features, steps, operations, elements, components, and/or groups thereof. In addition, it will be understood that, although the terms "first", "second", "third", etc. may be used herein to describe various elements, these elements should not be limited by these terms. Rather, these terms are only used to distinguish one element from another. For example, a first element could be termed a second element, and, similarly, a second element could be termed a first element, without departing from the scope of the present disclosure.

Relative terms, such as "lower", "bottom", or "below" and "upper", "top", or "above", may be used herein to describe one element's relationship to another element as illustrated in the drawings. It will be understood that relative terms are intended to encompass different orientations of the device in addition to the orientation depicted in the drawings. For example, if the device in the drawings is turned over, elements described as being on the "lower" or "bottom" side of other elements would then be oriented on the "upper" or "top" side of the other elements. The example term "lower" can, therefore, encompass both an orientation of "lower" and "upper", depending on the particular orientation of the figure. Similarly, the example term "below" can, therefore, encompass both an orientation of "below" and "above", depending on the particular orientation of the figure.

As used herein, the singular forms "a", "an", and "the" are intended to include the plural forms as well, unless the context clearly indicates otherwise. Additionally, the description may be specific to a portion of the semiconductor device and the described structure may be repeated in other portions of the semiconductor device. For example, the described structure may be an individual element of an array of elements forming the semiconductor device. Accordingly, where the structure of a single element of a plurality of elements has been described, this structure may equally apply to other elements of the plurality of elements.

## Claims

1. A semiconductor device, comprising:
a first semiconductor structure including a substrate, circuit elements on the substrate, a lower interconnection structure electrically connected to the circuit elements, and a first metal bonding layer on the circuit elements and the lower interconnection structure; and
a second semiconductor structure including a plate layer having at least one through-hole, gate electrodes stacked and spaced apart from each other in a first direction perpendicular to a lower surface of the plate layer, channel structures extending in the first direction through the gate electrodes, a capacitor structure spaced apart from the channel structures on the lower surface of the plate layer, and a second metal bonding layer below the channel structures and below the capacitor structure and bonded to the first metal bonding layer,
wherein the capacitor structure comprises:
a first electrode structure on the lower surface of the plate layer;
a second electrode structure that surrounds at least a portion of the first electrode structure and extends in the at least one through-hole; and
a dielectric liner that extends between the at least one through-hole and the second electrode structure and between the first electrode structure and the second electrode structure.

2. The semiconductor device of claim 1, further comprising an expansion cavity that is on the lower surface of the plate layer and is overlapped by the at least one through-hole in the first direction,
wherein at least a portion of the first electrode structure is in the expansion cavity, and
wherein the dielectric liner and the second electrode structure extend from the at least one through-hole and are on an inner surface of the expansion cavity.

3. The semiconductor device of claim 2, wherein the expansion cavity has a cylindrical shape that includes a side surface spaced apart from a side surface of the at least one through-hole.

4. The semiconductor device of claim 2 or claim 3, further comprising an insulating pattern that extends from the at least one through-hole and is surrounded by the second electrode structure in the expansion cavity.

5. The semiconductor device of any of claims 2-4, wherein the second electrode structure completely fills the at least one through-hole and extends from the at least one through-hole to the expansion cavity.

6. The semiconductor device of any of claims 2-5, wherein an upper surface of the first electrode structure is embedded within the plate layer, and
the dielectric liner is between the first electrode structure and the second electrode structure and between the expansion cavity and the second electrode structure in the expansion cavity.

7. The semiconductor device of any of claims 2-6, wherein a portion of the first electrode structure is on a side surface of the expansion cavity.

8. The semiconductor device of any of claims 2-7, wherein the expansion cavity includes a side surface that extends in the first direction and a bottom surface that extends from the side surface in a second direction intersecting the first direction, and
wherein the bottom surface of the expansion cavity is below a lower surface of the first electrode structure.

9. The semiconductor device of any preceding claim, further comprising a cell region insulating layer on the lower surface of the plate layer and the gate electrodes,
wherein the capacitor structure further comprises a dam structure that is on the lower surface of the plate layer and surrounds the first electrode structure, the second electrode structure, and the dielectric liner, and
wherein the dam structure extends in the cell region insulating layer in the first direction.

10. The semiconductor device of claim 9, wherein the dielectric liner extends between at least a portion of the dam structure and the second electrode structure.

11. The semiconductor device of any preceding claim, further comprising:
a first contact electrode on a lower surface of the first electrode structure and electrically connected to the first electrode structure; and
a second contact electrode on the second electrode structure and the at least one through-hole and electrically connected to the second electrode structure.

12. The semiconductor device of claim 11, wherein a portion of the first contact electrode adjacent to the lower surface of the first electrode structure is surrounded by the dielectric liner.

13. The semiconductor device of any of claims 1-10, further comprising:
a first contact electrode on an upper surface of the plate layer and electrically connected to the first electrode structure; and
a second contact electrode on the second electrode structure and the at least one through-hole and electrically connected to the second electrode structure.

14. The semiconductor device of any preceding claim, wherein at least a portion of the first electrode structure has a cylindrical shape with a width that becomes narrower toward the lower surface of the plate layer.

15. The semiconductor device of any preceding claim, wherein the first electrode structure includes a first lower electrode on the lower surface of the plate layer and a first upper electrode disposed below the first lower electrode, and
wherein each of the first lower electrode and the first upper electrode has a cylindrical shape with a width that becomes narrower toward a lower surface of the first upper electrode.
